Europäisches Patentamt

European Patent Office

Office européen des brevets

(19)

(11) EP 0 946 014 B1

(12) **FASCICULE DE BREVET EUROPEEN**

(45) Date de publication et mention
de la délivrance du brevet:
**03.11.2004 Bulletin 2004/45**

(51) Int Cl.⁷: **H04L 1/00**, H04L 25/03,
H03M 13/00

(21) Numéro de dépôt: **99400698.9**

(22) Date de dépôt: **22.03.1999**

(54) **Procédé de détection d'une séquence de symboles discrets à partir d'un signal d'observation, et processeur de viterbi mettant en oeuvre un tel procédé**

Verfahren zur Detektion einer Symbolfolge aus einem empfangenen Signal, und Viterbi-Prozessor zur Durchführung des Verfahrens

Method for detecting a sequence of symbols from a received signal, and Viterbi processor for carrying out the method

(84) Etats contractants désignés:
**CH DE FI GB LI**

(30) Priorité: **25.03.1998 FR 9803681**

(43) Date de publication de la demande:
**29.09.1999 Bulletin 1999/39**

(73) Titulaire: **NORTEL NETWORKS France
78117 Châteaufort (FR)**

(72) Inventeurs:
• **Belveze, Fabrice
78310 Maurepas (FR)**
• **Chancel, Florence
78000 Versailles (FR)**

(74) Mandataire: **Loisel, Bertrand
Cabinet Plasseraud
65/67 rue de la Victoire
75440 Paris Cedex 09 (FR)**

(56) Documents cités:
**EP-A- 0 727 890**

• NILL C ET AL: "VITERBI ALGORITHMS WITH LIST AND SOFT SYMBOL OUTPUT: EXTENSIONS AND COMPARISONS" PROCEEDINGS OF THE GLOBAL COMMUNICATIONS CONFERENCE (GLOBECOM), HOUSTON, USA, vol. 2, 29 novembre 1993 (1993-11-29) - 2 décembre 1993 (1993-12-02), pages 788-792, XP000427917 INSTITUTE OF ELECTRICAL AND ELECTRONICS ENGINEERS
• BERROU C ET AL: "A LOW COMPLEXITY SOFT-OUTPUT VITERBI DECODER ARCHITECTURE" PROCEEDINGS OF THE INTERNATIONAL CONFERENCE ON COMMUNICATIONS (ICC), GENEVA, MAY 23 - 26, 1993, vol. 2, 23 mai 1993 (1993-05-23), pages 737-740, XP000374202 INSTITUTE OF ELECTRICAL AND ELECTRONICS ENGINEERS
• LI Y ET AL: "Optimum soft-output detection for channels with intersymbol interference" IEEE TRANSACTIONS ON INFORMATION THEORY, vol. 41, no. 3, mai 1995 (1995-05), pages 704-713, XP002088078 USA, ISSN 0018-9448
• HAGENAUER J ET AL: "A VITERBI ALGORITHM WITH SOFT-DECISION OUTPUTS AND ITS APPLICATIONS" COMMUNICATIONS TECHNOLOGY FOR THE 1990'S AND BEYOND, DALLAS, NOV. 27 - 30, 1989, vol. 3, 27 novembre 1989 (1989-11-27), pages 1680-1686, XP000091258 INSTITUTE OF ELECTRICAL AND ELECTRONICS ENGINEERS

**Description**

La présente invention concerne le domaine des transmissions numériques.

On considère la transmission d'une information de nature numérique, c'est-à-dire sous forme de symboles prenant un nombre fini ND de valeurs $d^0,...d^{ND-1}$, et de manière discrète au cours du temps: c'est donc une séquence de symboles numériques $D_m$ (m=0,1,2,...) appartenant à un alphabet défini {$d^i$, $0 \leq <ND$}.

Le rôle du détecteur, au sens de la présente invention, est de fournir des estimations des symboles successifs $D_m$ d'une séquence à détecter à partir d'un signal d'observation "codé" disponible au niveau d'un récepteur. Le "codeur", qui fournit au détecteur le signal d'observation représentatif de la séquence à détecter doit être pris au sens le plus général: il peut être vu comme une boîte noire, développée par le concepteur ou non. Ce peut être par exemple un codeur correcteur d'erreurs (dans ce cas, le signal observation est également une séquence numérique, et le "détecteur" est un décodeur correcteur), ou un ensemble codeur correcteur - modulateur - canal de propagation - démodulateur (le signal observation est alors une suite numérique entachée d'erreurs), ou encore l'ensemble plus simple modulateur - canal de propagation (le "détecteur" est alors un démodulateur).

Le détecteur est à entrées rigides ("hard inputs") si le signal d'observation qu'il traite est une séquence numérique de symboles à valeurs discrètes, et à entrées souples ("soft inputs") si le signal d'observation est une séquence de valeurs échantillonnées et quantifiées, ou d'estimations discrètes assorties de pondérations respectives représentant les confiances qu'on a dans ces estimations.

Le détecteur est à sorties souples ("soft outputs") si les estimations de symbole qu'il délivre sont assorties de pondérations respectives représentant les confiances qu'on a dans ces estimations, et à sorties rigides ("hard outputs") s'il délivre simplement des estimations discrètes.

Dans les systèmes de transmission réels, il est courant de traiter des signaux possédant une mémoire, c'est-à-dire que le segment du signal portant l'information à un instant donné dépend non seulement de cette information au même instant, mais aussi de l'information passée ou des segments passés du signal. Si cette mémoire vérifie certaines propriétés, notamment le fait qu'existe un treillis décrivant le processus de production du signal d'observation, alors le récepteur peut décider des symboles d'information véhiculés par le signal d'observation au sens du maximum de vraisemblance, grâce à l'algorithme de Viterbi (voir G.D. Forney, Jr., "The Viterbi Algorithm", Proc. IEEE, Vol.61, No.3, mars 1973, pages 268-278) ou à l'algorithme MAP (Maximum A Posteriori) également exposé dans l'article de G.D. Forney.

Diverses versions de l'algorithme MAP sont décrites dans les références suivantes: K. Abend et B.D. Fritchman, "Statistical Detection for Communication Channels with Intersymbol Interference", Proc. IEEE, Vol.58, No.5, mai 1970, pages 779-785 ; R.W. Chang et J.C. Hancock, "On Receiver Structures for Channels Having Memory", IEEE Trans. on Information Theory, Vol.IT-12 No.4, octobre 1966, pages 463-468 ; et L.R. Bahl et al, "Optimal Decoding of Linear Codes for Minimizing Symbol Error Rate", IEEE Trans. on Information Theory, Vol.IT-20, mars 1974, pages 284-287.

Il arrive également que l'on cascade des "codeurs" $COD_1,COD_2,...,COD_N$ dans les systèmes de transmission (par exemple plusieurs codeurs correcteurs d'erreurs, ou un ou plusieurs codeurs correcteurs d'erreurs suivis par un modulateur et un canal de propagation), avec souvent des opérations d'entrelacement intermédiaires. Dans ce cas (système concaténé à mémoire), le récepteur considéré peut consister en une cascade de décodeurs/détecteurs élémentaires $DEC_N,DEC_{N-1},..,DEC_1$. Ce récepteur est optimal au sens du maximum de vraisemblance si les décodeurs/détecteurs $DEC_p$ sont à sorties souples (pour p>1) et à entrées souples, le décodeur/détecteur $DEC_p$ (p>1) associant à chaque estimation discrète d'un symbole décodé $D_m$ de la séquence à détecter (cette séquence est celle délivrée par le codeur $COD_{p-1}$) une pondération représentée par la vraisemblance égale ou proportionnelle au logarithme du rapport entre la probabilité que le symbole $D_m$ de la séquence inconnue corresponde effectivement à son estimation fournie par le décodage et la probabilité que le symbole $D_m$ soit différent de son estimation, les probabilités en question étant des probabilités conditionnelles, avec la connaissance du signal d'observation disponible. Dans ce cas, les sorties souples de chaque décodeur/détecteur constituent les "signaux d'observation" pour le décodeur/détecteur suivant, et l'information de vraisemblance n'est pas perdue.

L'algorithme de Viterbi a pour avantage que sa mise en oeuvre par un circuit ou un processeur n'entraîne pas de grandes difficultés, étant donné la simplicité des opérations effectuées : multiplications, additions/soustractions, comparaisons. En outre, la régularité des treillis permet souvent d'utiliser des astuces de programmation ou d'organisation de la mémoire, qui facilitent encore la mise en oeuvre de l'algorithme. Ceci explique que son utilisation soit aujourd'hui très répandue dans diverses catégories de détecteurs. Mais, dans sa version traditionnelle, il ne fournit pas la vraisemblance des estimations discrètes qu'il délivre, de sorte qu'il ne permet pas le traitement optimal dans le cas d'un système concaténé à mémoire.

En revanche, l'algorithme MAP, par essence, fournit les vraisemblances des symboles qu'il estime, mais il pose de sérieuses difficultés d'implémentation : calculs d'exponentielles, nécessité de connaître la variance du bruit, sensibilité aux erreurs sur cette variance, problèmes d'analyse numérique pour ses très petites valeurs...

Pour les systèmes concaténés à mémoire évoqués ci-dessus, il a été proposé plusieurs méthodes de pondération des estimations produites par un détecteur de Viterbi. Des exemples de telles méthodes, dites "SOVA" (Soft Output Viterbi Algorithm), sont :

- une méthode consistant à prendre comme vraisemblance d'une estimation la différence entre la métrique accumulée au niveau d'un noeud du treillis correspondant à cette estimation et la métrique du meilleur chemin correspondant à une estimation discrète différente (voir C. Berrou et al, "A Low Ccmplexity Soft-Output Viterbi Decoder Architecture", Proc. ICC'93, Genève, mai 1993). Cette technique simple est couramment employée, mais très sous-optimale ;
- l'algorithme de Hagenauer, décrit dans J. Hagenauer et P. Hoeher, "A Viterbi Algorithm with Soft-Decision Outputs and its Applications", Proc. Globecom'89, Dallas, novembre 1989, pages 47.1.1-47.1.7 ;
- l'algorithme de Battail, décrit dans le brevet américain 4 328 582 ;
- le SOVA optimal (OSA) ou sous-optimal (SSA) décrit dans Y. Li, B. Vucetic et Y. Sato, "Optimum Soft-Output Detection for Channels with Intersymbol Interference", IEEE Trans. on Information Theory, Vol.IT-41, No.3, mai 1995, pages 704-713.

A l'exception de l'OSA, chacune de ces méthodes SOVA apporte une dégradation de performances par rapport à l'algorithme MAP.

Les algorithmes de Hagenauer, de Battail et de Li, Vucetic et Sato s'apparentent au MAP en ce qu'ils effectuent les calculs dans le domaine des probabilités. En conséquence, ils impliquent le calcul d'exponentielles, ce qui rend peu attractive leur mise en oeuvre à l'aide de circuits ou de processeurs, même si les exponentielles sont remplacées par des approximations.

Un but principal de la présente invention est de proposer une méthode SOVA de complexité raisonnable, permettant une évaluation des vraisemblances des symboles estimés par un détecteur de Viterbi, et qui apporte peu de dégradation de la probabilité d'erreur par rapport au cas optimal de l'algorithme MAP.

L'invention propose ainsi un procédé de détection d'une séquence de symboles discrets à partir d'un signal d'observation dont la production peut être décrite à l'aide d'un treillis de NE états $E_e$ ($0 \leq e < NE$) et NB branches $B_b$ ($0 \leq b < NB$), chaque branche ayant un état de départ et un état d'arrivée parmi les NE états et étant associée à un unique Q-uplet de symboles discrets, Q étant un entier au moins égal à 1,

le treillis comportant des chemins formés chacun par une succession de branches, chaque chemin ayant une métrique définie par une somme de métriques élémentaires relatives aux branches successives qui le forment, et étant associé à une unique séquence possible de symboles discrets formée par la succession des Q-uplets auxquels sont respectivement associées les branches successives formant ledit chemin,

dans lequel le signal d'observation est traité par segments temporels successifs, le traitement effectué pour un segment n du signal d'observation comprenant :

- pour chacune des NB branches $B_b$ ($0 \leq b < NB$), l'obtention d'une métrique élémentaire correspondant à une combinaison entre le segment n du signal d'observation et un signal de référence associé à la branche $B_b$, et le calcul d'une métrique de branche accumulée $MBA_b(n)$ en ajoutant la métrique élémentaire obtenue à une métrique d'état accumulée $MEA_e(n-1)$ relative à l'état de départ $E_e$ de la branche $B_b$; et
- pour chacun des NE états $E_e$ ($0 \leq e < NE$), la mise à jour de la métrique d'état accumulée $MEA_e(n)$, prise égale à un optimum des métriques de branche accumulées $MBA_b(n)$ relatives à celles des branches $B_b$ qui ont l'état $E_e$ comme état d'arrivée, et la mémorisation d'une identification d'une branche survivante pour laquelle ledit optimum est atteint,

dans lequel, après avoir traité des segments successifs du signal d'observation, on sélectionne l'un des NE états $E_{e0}$ et un chemin optimal $\alpha_{opt}$ du treillis formé en remontant les branches survivantes depuis l'état sélectionné, et on estime au moins un symbole discret $D_m$ de la séquence à détecter par la valeur d'un symbole correspondant de la séquence à laquelle est associé le chemin optimal sélectionné,

et dans lequel, pour chaque symbole $D_m$ de la séquence à détecter, estimé après la sélection d'un état $E_{e0}$ et d'un chemin optimal $\alpha_{opt}$, on calcule une différence de métriques minimale entre le chemin optimal et un chemin concurrent associé à une séquence dont le symbole correspondant au symbole $D_m$ a une valeur autre que l'estimation retenue pour le symbole $D_m$, et on détermine la vraisemblance $\Lambda_m$ de l'estimation du symbole $D_m$ en fonction de la différence de métriques minimale calculée.

La vraisemblance $\Lambda_m$ de l'estimation d'un symbole $D_m$ peut notamment être prise égale ou proportionnelle à la différence de métriques minimale calculée pour ce symbole.

Les inventeurs ont observé (par simulation) que ce procédé de détection offre des performances proches du MAP en ce qui concerne le taux d'erreur. Son autre avantage est d'utiliser le même type d'opérations simples que l'algorithme de Viterbi classique (uniquement additions/soustractions et comparaisons) . Sa complexité lui est comparable : la quantité de calculs requise pour obtenir les vraisemblances équivaut approximativement à celle requise par l'algorithme de Viterbi à sorties discrètes. Mais il a le grand avantage de produire les vraisemblances des décisions. On sait que sur un simple canal gaussien, on peut avoir un gain allant jusqu'à près de 3 dB (pour les grands rapports signal-sur-bruit) sur chacun des étages de décodage. L'intérêt de disposer d'un tel procédé est donc grand.

Les applications visées sont les concaténations de décodage, parmi lesquelles:

- une démodulation d'un système à mémoire, qui doit être suivie d'un décodage à entrées souples d'un code convolutif (avec ou sans entrelacement) ou d'un code en bloc; le système à mémoire peut être une transmission sur un canal à interférence entre symboles, et/ou une modulation à phase continue (CPM: "continuous phase modulation", dont un exemple est la GMSK: "gaussian minimum shift keying") ou linéaire ;
- deux (ou plus) décodages souples de codes convolutifs concaténés (avec ou non présence d'entrelacement entre les codes); un exemple d'application dans ce cas est le décodage des turbo-codes; ou encore le décodage souple d'un code convolutif suivi du décodage souple d'un code en bloc ;
- le décodage souple d'un code convolutif, suivi d'un décodeur d'images ou de parole, qui aurait besoin de connaître la qualité des symboles (binaires ou non) décodés, afin d'améliorer la qualité du signal restitué (exemple: décodeur de parole dans un système de radiocommunication cellulaire de type GSM) ;
- dans un système de reconnaissance de formes (reconnaissance d'images, de caractères ou de parole) utilisant la modélisation par chaînes de Markov cachées (et qui utilise donc généralement un algorithme de Viterbi pour prendre sa décision) et ayant besoin de connaître la vraisemblance de la décision (par exemple pour justement ne pas prendre de décision dans le cas où la vraisemblance n'atteint pas un certain seuil).

Dans un mode de réalisation préféré du procédé, lors des traitements effectués pour L0+L1 segments temporels successifs n-r du signal d'observation jusqu'à un segment n (n-L0-L1<n-r≤n), L0 étant un entier positif ou nul et L1 étant un entier strictement positif, on mémorise pour chaque branche b (0≤b<NB) l'écart $\delta_b(n-r)=|MBA_b(n-r)-MEA_e(n-r)|$ entre la métrique de branche accumulée $MBA_b(n-r)$ et la métrique d'état accumulée $MEA_e(n-r)$ mise à jour pour l'état d'arrivée $E_e$ de la branche $B_b$. Après le traitement de L1 segments successifs du signal d'observation jusqu'à un segment n et la sélection d'un état $E_{e0}$, on procède à un calcul récursif sur la base des écarts de métriques mémorisés lors des traitements effectués pour les L0+L1 segments précédents n-r (n-L0-L1<n-r≤n), pour déterminer la différence de métriques minimale relativement à chaque symbole $D_m$ estimé à l'aide de la séquence à laquelle est associé le chemin optimal déterminé en remontant les branches survivantes depuis l'état sélectionné.

Dans ces conditions, on peut, après le traitement de L1 segments successifs du signal d'observation jusqu'à un segment n et la sélection d'un état, estimer $Q{\times}L1$ symboles $D_m$ relatifs aux L1 segments antérieurs n-r tels que n-L0-L1<n-r≤n-L0, et déterminer les vraisemblances respectives des estimations de ces QxL1 symboles $D_m$, les estimations de Q symboles relatifs à un segment antérieur n-r étant respectivement formées par les valeurs du Q-uplet de symboles auquel est associée la (r+1)-ième branche survivante du chemin optimal parcouru en remontant depuis l'état sélectionné.

Les paramètres L0 et L1 sont choisis selon le compromis recherché entre l'espace mémoire nécessaire à l'exécution du procédé et la quantité de calculs à effectuer.

Avantageusement, une fois qu'on a sélectionné un état $S_{e0}$ après le traitement de L1 segments successifs du signal d'observation jusqu'à un segment n, on initialise des notes d'état $X_e$ relatives aux NE états $E_e$ (0≤e<NE) selon $X_e=|MEA_e(n)-MEA_{e0}(n)|$, puis on exécute les opérations suivantes pour chaque valeur de l'entier r allant de 0 à L0+L1-1 :

- la sélection de la branche survivante $B_{b0}$ mémorisée, pour l'état sélectionné $E_{e0}$, lors du traitement effectué pour le segment n-r, suivie par la mise à jour de l'état sélectionné $E_{e0}$ pris comme étant l'état de départ de la branche survivante sélectionnée $B_{b0}$ ;
- pour chacune des NB branches $B_b$ (0≤b<NB), le calcul d'une note de branche $Z_b$ en ajoutant à la note d'état $X_e$ relative à l'état d'arrivée $E_e$ de la branche $B_b$ l'écart de métriques $\delta_b(n-r)$ mémorisé pour la branche $B_b$;
- pour chacun des NE états $E_e$ (0≤e<NE) , la mise à jour de la note d'état $X_e$, prise égale à la plus petite des notes de branche $Z_b$ calculées pour celles des branches $B_b$ qui ont l'état $E_e$ comme état de départ ;
- si r≥L0, l'estimation de Q symboles de la séquence à détecter, par les valeurs du Q-uplet de symboles auquel est associée la branche survivante sélectionnée $B_{e0}$ ; et
- si r≥L0, pour chaque estimation $d^i$ retenue pour l'un des Q symboles $D_m$, la détermination de la différence de métriques minimale comme étant la plus petite des notes de branche $Z_p$ calculées pour celles des branches $B_b$ qui sont associées à des Q-uplets dont le symbole correspondant au symbole $D_m$ a une valeur $d^j$ différente de l'estimation $d^i$.

Un autre aspect de la présente invention se rapporte à un processeur de Viterbi, comprenant des moyens de calcul de métriques élémentaires et des moyens de traitement séquentiel adaptés à la mise en oeuvre du procédé ci-dessus. Un tel processeur de Viterbi peut notamment faire partie d'un démodulateur de signal numérique, ou encore d'un décodeur tel qu'un décodeur correcteur d'erreurs.

L'invention sera mieux comprise à la lecture de la description détaillée ci-après d'exemples de réalisation non limitatifs, en référence aux dessins annexés, dans lesquels :

- les figures 1 et 2 sont des diagrammes d'un exemple de treillis de démodulation et d'un exemple de treillis de décodage correcteur d'erreurs ;
- la figure 3, constituée en plaçant les figures 3A, 3B et 3C les unes au-dessus des autres, est un organigramme d'un procédé de détection conforme à l'invention ;
- les figures 4 et 5 sont des schémas synoptiques d'un émetteur de radiocommunication, et d'un récepteur correspondant mettant en oeuvre l'invention ;
- les figures 6 et 7 sont des schémas synoptiques d'un émetteur de signal numérique, et d'un récepteur correspondant mettant en oeuvre l'invention ; et
- la figure 8 est un graphique illustrant l'amélioration des performances procurée par la mise en oeuvre de l'invention dans un exemple de démodulateur numérique.

Un processus de Markov, modélisant la production d'un signal d'observation R à partir d'une séquence de symboles discrets $D_0$, $D_1$,...,$D_m$,... peut être décrit par un treillis possédant NE états $E_e$ ($0 \leq e < NE$) et NB branches élémentaires $B_b$ ($0 \leq b < NB$). Chaque symbole discret de la séquence peut prendre un nombre ND de valeurs distinctes $d^0, d^1,..., d^{ND-1}$. Chaque branche $B_b$ a un état de départ $E_{P(b)}$ et un état d'arrivée $E_{s(0)}$ ($0 \leq P(b) < NE$, $0 \leq S(b) < NE$), et est associée à un unique Q-uplet de symboles discrets $d^{idec(b,0)},..., d^{idec(b,Q-1)}$, Q étant un entier au moins égal à 1. A chaque couple formé par un état $E_e$ et un Q-uplet de symboles correspond une unique branche $B_b$ associée à ce Q-uplet et ayant l'état $E_e$ comme état de départ (e=P(b)).

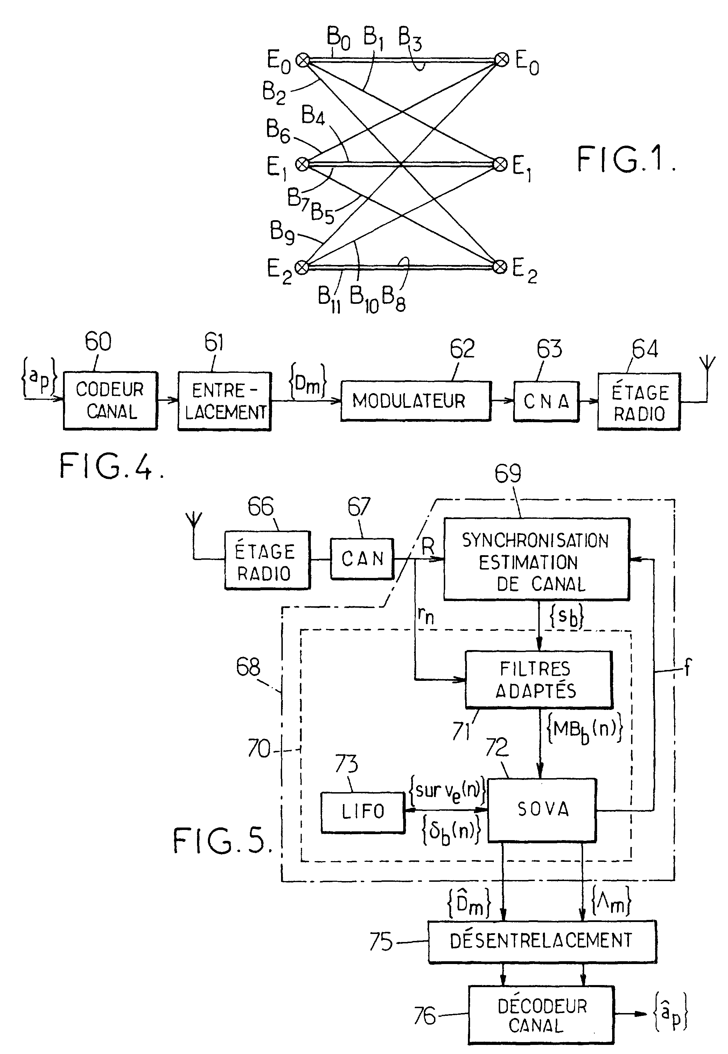

A titre d'illustration, la figure 1 montre un tel treillis à NE=3 états et NB=12 branches, dans lequel l'état de départ $E_{p(b)}$ d'une branche $B_b$ a pour index le quotient de la division euclidienne de b par 4 (P(b) = b div 4), et l'état d'arrivée $E_{S(b)}$ d'une branche $B_b$ a pour index le reste de la division euclidienne de b par 3 (S(b) = b mod 3). Chaque branche $B_b$ est associée à deux bits qui correspondent par exemple au reste de la division euclidienne de b par 4 (b mod 4). Dans cet exemple, les symboles peuvent être soit quaternaires (Q=1, ND=4, avec idec(b,0) = b mod 4), soit binaires (ND=2, Q=2, avec idec(b,q) = bit de poids $2^q$ de b mod 4).

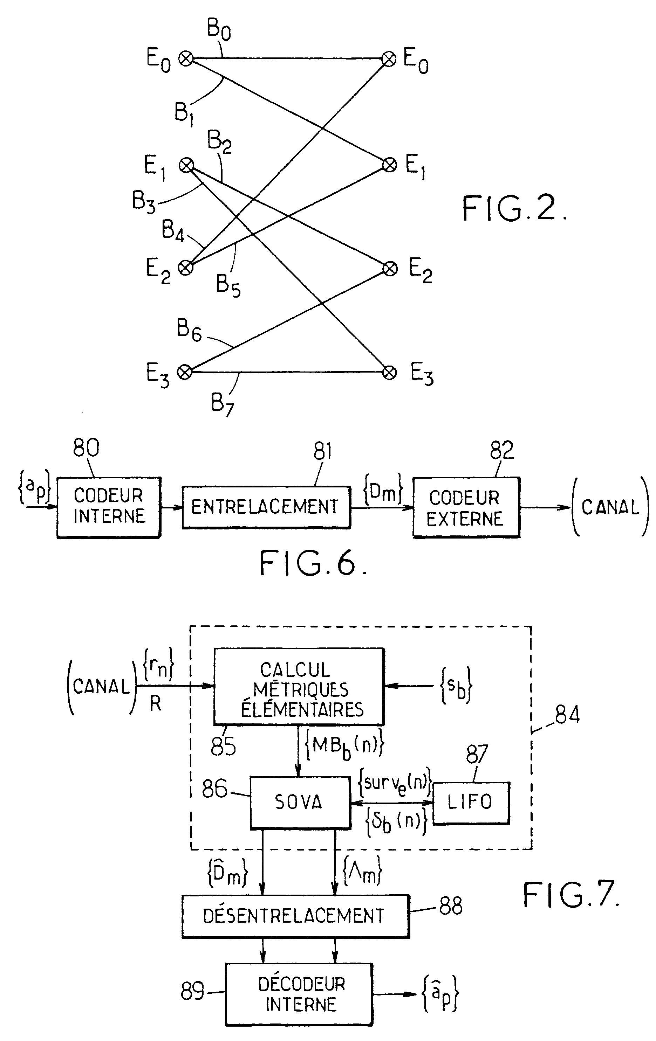

La figure 2 montre un autre exemple de treillis à NE=4 états et NB=8 branches, dans lequel P(b) = b div 2, et S(b) = b mod 4. Dans cet exemple, les symboles sont binaires (ND=2, Q=1, avec idec(b,0) = b mod 2).

On considère un treillis de ce genre développé sur L étapes relatives à L segments temporels successifs n du signal d'observation R ($0 \leq n < L$), correspondant à L×Q symboles de la séquence à détecter. Les segments successifs du signal d'observation présentent éventuellement des recouvrements. Chaque chemin dans le treillis, qui consiste en une succession de branches $B_{b(0)}, B_{b(1)},..., B_{b(L-1)}$ telles que S[b(n-1)]=P[b(n)] pour 0<n<L-1, est associé à une unique séquence possible de L×Q symboles consistant en la succession des Q-uplets auxquels sont respectivement associées les branches $B_{b(0)}, B_{b(1)},..., B_{b(L-1)}$.

Le treillis décrit la production du signal d'observation en ce sens que la loi de probabilité d'un segment n du signal d'observation est déterminée par la branche $B_{b(n)}$ empruntée dans le treillis à l'étape n correspondante, ou en d'autres termes par l'état de départ $E_{P[b(n)]}$ qui garde une certaine mémoire des symboles antérieurs et par le Q-uplet de symboles auquel est associée la branche $B_{b(n)}$. La détection selon le maximum de vraisemblance consiste dès lors à identifier le chemin optimal dans le treillis, c'est-à-dire la succession de branches qui maximise la probabilité d'occurrence du signal d'observation recueilli. Les symboles estimés sont alors extraits de la séquence à laquelle est associé ce chemin optimal.

L'identification du chemin optimal revient à une maximisation (ou à une minimisation selon les conventions employées) d'une métrique accumulée le long du chemin, égale à une somme de métriques élémentaires calculées pour les branches successives formant le chemin, les métriques élémentaires rendant compte de la dépendance probabiliste entre les segments du signal d'observation et les branches.

Désignons par M($\alpha$) la métrique d'un chemin $\alpha$ du treillis développé sur les L étapes, par $CB_b(n)$ l'ensemble des chemins du treillis qui empruntent la branche $B_b$ à l'étape n, par

$$CE_e(n) = \bigcup_{\substack{0 \leq b < NB \\ S(b) = e}} CB_b(n)$$

l'ensemble des chemins du treillis qui arrivent à l'état $E_e$ à l'étape n, et par $MEA_e(n,\alpha)$ la métrique d'un chemin $\alpha$ de $CE_e(n)$ accumulée jusqu'à l'étape n seulement.

On considère ci-après le cas où la métrique élémentaire $MB_b(n)$ calculée pour la branche $B_b$ à l'étape n est le produit scalaire $Re(<s_b|r_n>)$ entre le segment n du signal d'observation R (segment formé d'échantillons réels ou complexes notés $r_n$) et un signal de référence $s_b$ réel ou complexe associé à la branche $B_b$, les signaux de référence $s_b$ étant établis de façon que l'optimisation des métriques soit une maximisation (ce serait une minimisation si, avec les mêmes signaux de référence $s_b$, on retenait comme métrique élémentaire le carré de la distance euclidienne entre le segment $r_n$ et le signal de référence $S_b$, soit $\|r_n - s_b\|^2$).

L'algorithme de Viterbi tire parti du fait que le "meilleur" chemin de l'ensemble $CE_e(n)$, c'est-à-dire celui qui optimise (maximise dans le cas considéré) la métrique totale $M(\alpha)$ sur les L étapes, optimise aussi la métrique $MEA_e(n,\alpha)$. En conséquence, à chaque étape n (n allant de 0 à L-1), il suffit de mémoriser, pour chaque état $E_e$, la métrique accumulée :

$$MEA_e(n) = \max_{\alpha \in CE_e(n)} [MEA_e(n,\alpha)] = \max_{\substack{0 \le b < NB \\ S(b)=e}} [MBA_b(n)] \qquad (1)$$

ainsi que l'index $surv_e(n)$ de la branche, dite branche survivante, ayant l'état $E_e$ comme état d'arrivée et pour laquelle la métrique de branche accumulée, définie par $MBA_b(n) = MEA_{p(b)}(n-1) + MB_b(n)$, est optimale :

$$surv_e(n) = \underset{\substack{0 \le b < NB \\ S(b)=e}}{\arg\max} [MBA_b(n)] \qquad (2)$$

Au bout des L étapes, l'algorithme de Viterbi sélectionne l'un des NE états, et construit le chemin optimal en remontant les branches survivantes depuis cet état sélectionné.

L'état sélectionné peut être celui pour lequel la métrique d'état accumulée $MEA_e(L-1)$ est optimale si aucune condition aux limites n'est imposée. Il peut encore être un état prédéterminé si la séquence se termine par des symboles connus. De façon semblable, l'initialisation de l'algorithme, par les valeurs des métriques $MEA_e(-1)$, dépend de la connaissance qu'on a a priori du commencement de la séquence à détecter.

On désigne maintenant par $MX_e(n)$ la "meilleure" des métriques totales des chemins arrivant à l'état $E_e$ à l'étape n, et par $MZ_b(n)$ la "meilleure" des métriques totales des chemins passant par la branche $B_b$ à l'étape n:

$$MX_e(n) = \max_{\alpha \in CE_e(n)} [M(\alpha)] = \max_{\substack{0 \le b < NB \\ S(b)=e}} [MZ_b(n)] \qquad (3)$$

$$MZ_b(n) = \max_{\alpha \in CB_b(n)} [M(\alpha)] \qquad (4)$$

On désigne enfin par

$$CD_q^i(n) = \bigcup_{\substack{0 \le b < NB \\ idec(b,q)=i}} CB_b(n)$$

l'ensemble des chemins du treillis qui sont associés à des séquences dont le symbole $D_m$ de position m=nQ+q prend la valeur $d^1$ ($0 \le i < ND$, $0 \le q < Q$, $0 \le n < L$), et par $MD_q^i(n)$ la "meilleure" des métriques totales des chemins de l'ensemble $CD_q^i(n)$ :

$$MD_q^i(n) = \max_{\substack{\alpha \in CD_q^i(n)}} [M(\alpha)] = \max_{\substack{0 \leq b < NB \\ idec(b,q)=i}} [MZ_b(n)] \qquad (5)$$

L'algorithme de Viterbi classique ne calcule pas les quantités $MX_e(n)$, $MZ_b(n)$ et $MD_q^i(n)$. Néanmoins, à chacune des étapes n, le chemin optimal $\alpha_{opt}$ qu'il détermine passe par la branche $B_{b0}(n)$ qui optimise la quantité $MZ_b(n)$, et arrive à l'état $E_{e0}(n)$ qui optimise la quantité $MX_e(n)$ :

$$b0(n) = \underset{0 \leq b < NB}{argmax} [MZ_b(n)] \qquad (6)$$

$$e0(n) = \underset{0 \leq e < NE}{argmax} [MX_e(n)] \qquad (7)$$

Le vraisemblance de l'estimation $d^i$ d'un symbole $D_m = D_{nQ+q}$ obtenue par l'algorithme de Viterbi est proportionnelle au rapport logarithmique de probabilités conditionnelles

$$LLR_m^i = \ln\left(\frac{Pr\left(D_m = d^i|R\right)}{Pr\left(D_m \neq d^i|R\right)}\right)$$

soit :

$$LLR_m^i = \ln\left(\frac{\sum_{\alpha \in CD_q^i(n)} exp\left(2\,M(\alpha)/\sigma^2\right)}{\sum_{\substack{j=0 \\ j \neq i}}^{ND-1} \sum_{\alpha \in CD_q^j(n)} exp\left(2\,M(\alpha)/\sigma^2\right)}\right) \qquad (8)$$

où $\sigma^2$ est la variance du bruit contenu dans le signal d'observation.

En approchant les sommes d'exponentielles par l'exponentielle la plus grande, approximations qui se compensent dans une large mesure au numérateur et au dénominateur, l'expression (8) devient :

$$LLR_m^i \approx \ln\left(\frac{exp\left(2\,M(\alpha_{opt})/\sigma^2\right)}{\sum_{\substack{j=0 \\ j \neq i}}^{ND-1} exp\left(2\,MD_q^j(n)/\sigma^2\right)}\right) \qquad (9)$$

Si les symboles estimés sont binaires (ND=2), on peut donc prendre comme vraisemblance de l'estimation $d^i$ du symbole $D_m$ la quantité :

$$\Lambda_m = | M(\alpha_{opt}) - MD_q^{1'}(n)| \tag{10}$$

$$= M(\alpha_{opt}) - MD_q^{i'}(n) \approx \left(\frac{\sigma^2}{2}\right) . LLR_m^i \tag{11}$$

ou une quantité proportionnelle, $d^{i'}$ étant la décision différente de l'estimation retenue $d^1$. La vraisemblance pourra également être évaluée selon la relation (10) dans un cas non binaire (ND>2), $d^{i'}$ étant alors la "meilleure" décision différente de l'estimation retenue $d^i$ :

$$i' = \underset{\substack{1 \le j < ND \\ j \ne i}}{argmax} [MD_q^j(n)] \tag{12}$$

La métrique optimale $M(\alpha_{opt})$ est calculée par l'algorithme de Viterbi classique, contrairement à la métrique $MD_q^{i'}(n)$ du chemin concurrent.

Pour accéder à la métrique $MD_q^{i'}(n)$ du chemin concurrent, il est possible de procéder à un calcul récursif des quantités $MX_e(n)$ et $MZ_b(n)$, de la manière suivante :

- à chaque étape n du parcours du treillis dans le sens direct, mémoriser pour chaque branche $B_b$ ($0 \le b < NB$) l'écart de métriques $\delta_b(n)=|MBA_b(n)-MEA_{S(b)}(n)|= MEA_{S(b)}(n)-MBA_b(n)$ ;
- après la sélection d'un état e0 à l'étape n, obtenir les métriques $MX_e(n)=MEA_e(n)$ pour $0 \le e < NE$ ;
- à chaque étape n-r du parcours du treillis dans le sens inverse (r=0,1,... ), exécuté après la sélection d'un état à l'étape n, calculer pour chaque branche $B_b$ ($0 \le b < NB$) la métrique $MZ_b(n-r)=MX_{S(b)}(n-r) + \delta_b(n-r)$, puis, pour $0 \le e < NE$, calculer :

$$MX_e(n-r-1) = \underset{\substack{0 \le b < NB \\ P(b)=e}}{max} MZ_b(n-r) \tag{13}$$

On dispose ainsi des métriques $MZ_b(n)$ définies dans la relation (4), en ayant simplement mémorisé les écarts $\delta_b(n)$ (ou des quantités permettant de les retrouver aisément) et en ayant exécuté un nombre limité d'opérations peu complexes (additions/soustractions, comparaisons). A partir des métriques $MZ_b(n)$, il est facile de déduire les métriques $MD_q^i(n)$ conformément à la relation (5), d'identifier les métriques $MD_q^{i'}(n)$ des chemins concurrents pour chaque symbole estimé, et donc de fournir une bonne mesure des vraisemblances.

Si, dans un cas non binaire (ND>2), il s'avère que des chemins concurrents conduisant à des décisions différentes $d^{i'} \ne d^{1''}$ ont des métriques proches $MD_q^{i'}(n) \approx MD_q^{i''}(n) < MD_q^1(n)=M(\alpha_{opt})$, une option est d'améliorer l'approximation de la vraisemblance par rapport à l'expression (10) en retranchant un terme correctif. Dans le pire cas, où les métriques optimales relatives à toutes les décisions possibles sont égales ($MD_q^{i'}(n)=MD_q^{i''}(n)\ \forall i',i'' \ne i$), la plus petite différence de métriques $M(\alpha_{opt}) -MD_q^{i'}(n)$ devient, d'après la relation (9) :

$$M(\alpha_{opt}) - MD_q^{i'}(n) \approx \left(\frac{\sigma^2}{2}\right) . [LLR_m^i + ln(ND-1)] \tag{14}$$

Le terme correctif peut être proportionnel à $\sigma^2$ (qui doit alors être estimé), avec un coefficient multiplicateur qui décroît de (1/2).ln(ND-1) à 0 avec la dispersion des métriques des chemins concurrents.

Si la mise en oeuvre de l'algorithme de Viterbi est fondée sur une métrique élémentaire à minimiser, telle que le carré de la distance euclidienne, il va de soi que les maxima des relations (1) à (7), (12) et (13) doivent être remplacés par des minima, les écarts de métriques $\delta_b(n)$ étant égaux à $MBA_b(n)-MEA_{s(b)}(n)$, et la vraisemblance $\Lambda_m$ selon le relation (10) devenant :

$$\Lambda_m = MD\frac{i'}{q}(n) - M(\alpha_{opt}) \approx \sigma^2 . LLR\frac{i}{m} \tag{15}$$

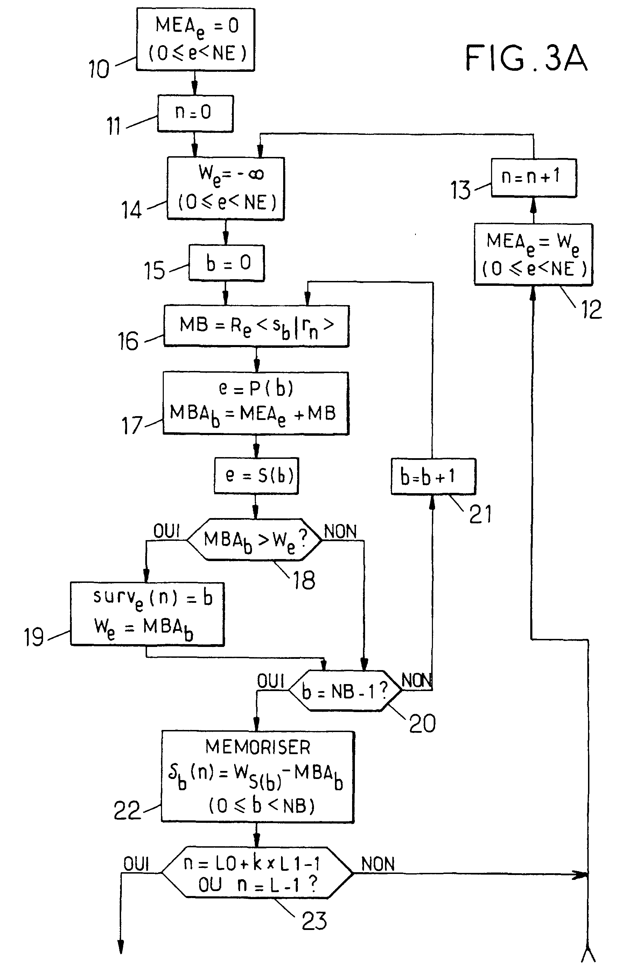

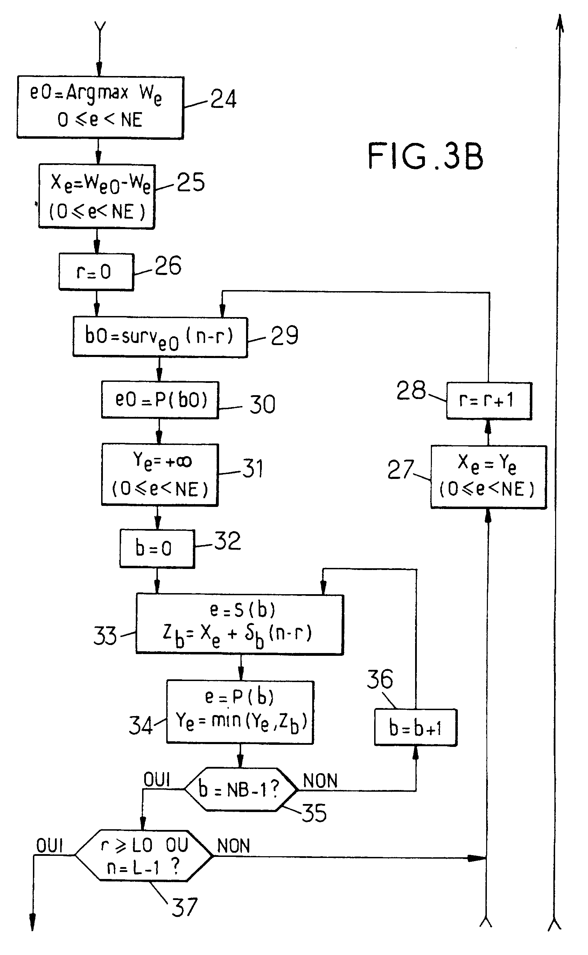

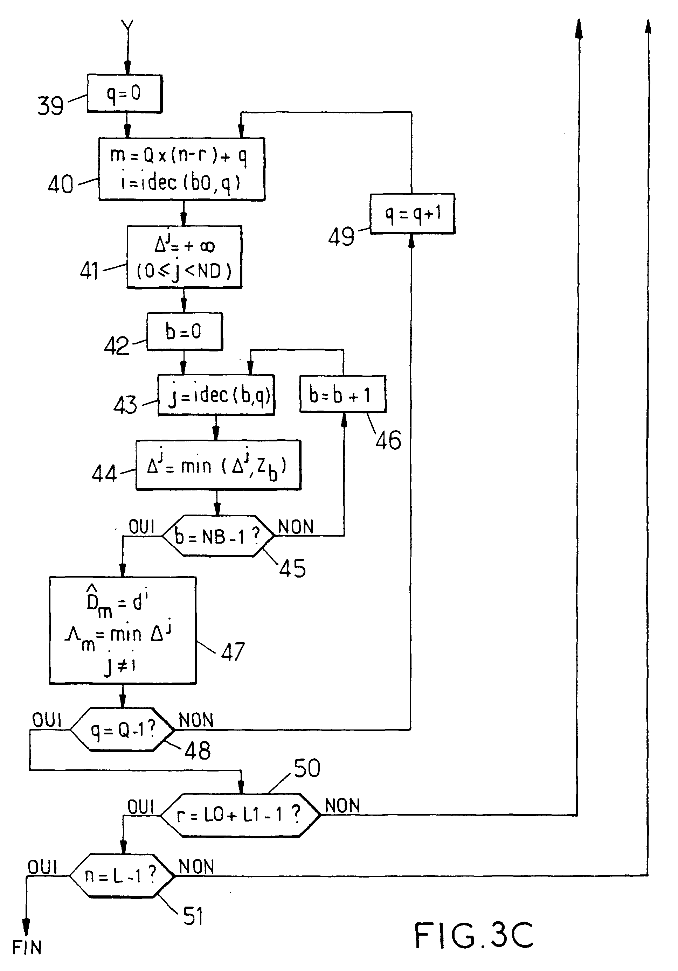

La figure 3 illustre un exemple de réalisation d'un procédé selon l'invention, dans lequel, pour limiter encore les calculs, on ne calcule pas explicitement les métriques $MX_e(n)$, $MZ_b(n)$ (relations (3) et (4)), mais les différences entre la métrique $M(\alpha_{opt})$ du chemin optimal déterminé selon l'algorithme de Viterbi et ces métriques $MX_e(n)$, $MZ_b(n)$.

Le procédé illustré par la figure 3 comporte, pour le parcours direct dans le treillis, une boucle principale sur l'index n des segments du signal d'observation reçu. Un parcours inverse ("backtracking" ) est effectué dans le treillis toutes les L1 itérations dans cette boucle, le premier parcours inverse étant effectué à l'issue des L0+L1 premières itérations. Les paramètres entiers L0 et L1 sont choisis tels que $1 \leq L1 \leq L$ et $0 \leq L0 \leq L-L1$. Lors du parcours inverse effectué à l'issue des L0+kxL1 premières itérations ($k \geq 1$), on calcule les estimations des symboles $D_Q . (k-1).L1$ à $D_{Q.k.L1-1}$et les vraisemblances correspondantes.

Les écarts de métriques $\delta_b(n)$ et les branches survivantes $surv_e(n)$ sont mémorisés pendant L0+L1 itérations consécutives dans la boucle afin d'être disponibles pour chaque parcours inverse. Les autres grandeurs calculées peuvent n'être mémorisées que pendant l'itération courante (en conséquence, on abandonne la référence à n dans les notations employées sur la figure 3 pour ces grandeurs).

Le nombre L0+L1 détermine donc la taille de la mémoire requise pour le calcul des vraisemblances. En général, L0 pourra être égal à la profondeur de troncature (notée δ dans l'article précité de G.D. Forney) à partir de laquelle il est très probable que tous les chemins survivants aient fusionné. Une grande valeur de L1 conduit à une taille de mémoire relativement importante, mais limite les calculs à effectuer. A la limite, si L1=L (L0=0), le parcours inverse n'est effectué qu'une fois, en nécessitant la sauvegarde des écarts de métriques $\delta_b(n)$ sur toute la longueur L du treillis. Inversement, une petite valeur de L1 limite la taille de mémoire, mais requiert davantage de calculs. A la limite, si L1=1, un parcours inverse de profondeur L0+1 est effectué à chaque itération à partir de n=L0, pour n'estimer que Q symboles à la fois.

Dans l'itération n de la boucle principale, $MEA_e$ ($0 \leq e < NE$) représente la métrique d'état $MEA_e(n-1)$ accumulée jusqu'à l'étape n-1, et $W_e$ représente la métrique d'état accumulée $MEA_e(n)$ calculée au cours de l'étape n. Avant de procéder à une nouvelle itération (initialisation 11 par n=0, ou incrémentation de l'index n à l'étape 13), les métriques d'état accumulées $MEA_e$ sont mises à jour à l'étape 10 ou 12. A l'étape 12, la mise à jour consiste simplement à prendre $MEA_e=W_e$ pour $0 \leq e < NE$. A l'étape 10, les valeurs $MEA_e(-1)$ relatives aux conditions initiales sont adoptées. Dans l'exemple représenté sur la figure 3A, on n'a aucune connaissance a priori de l'état de départ, de sorte que les métriques $MEA_e$ sont toutes initialisées à la même valeur (0) à l'étape 10. Si l'état de départ est connu (par exemple parce que la séquence à détecter est précédée par une séquence de synchronisation connue), on peut affecter une métrique initiale nulle à cet état connu et des métriques arbitrairement faibles (-∞) aux autres états.

Dans chaque itération n, on commence par donner des valeurs arbitrairement faibles (-∞) aux variables $W_e$, et par initialiser à 0 l'index de branche b (étapes 14 et 15). Pour chaque valeur de b, la métrique élémentaire $MB=MB_b$ (n) est calculée à l'étape 16, dans l'exemple considéré par le produit scalaire entre le segment $r_n$ du signal d'observation et le signal de référence $s_b$ associé à la branche $B_b$. A l'étape 17, la métrique de branche accumulée $MbA_b \approx MBA_b$ (n) est calculée en ajoutant la métrique élémentaire MB à la métrique d'état accumulée $MEA_{p(b)}$ relative à l'état de départ de la branche $B_b$. A l'étape 18, la métrique de branche accumulée $MBA_b$ précédemment calculée est comparée à la variable $W_{S(b)}$. On prend $surv_{S(b)}(n)=b$ et $W_{S(b)}=MBA_b$ à l'étape 19 seulement si $MBA_b>W_e$. Ensuite, l'index de branche b est comparé au nombre de branches NB à l'étape 20. Si b<NB-1, l'index b est incrémenté d'une unité à l'étape 21, avant de revenir à l'étape 16 pour le traitement de la branche suivante.

Quand b=NB-1 à l'étape 20, les nouvelles métriques d'état accumulées sont contenues dans les variables $W_e$, et les branches survivantes dans les variables $surv_e(n)$ qui sont gardées en mémoire. L'opération suivante 22 est la mémorisation des écarts de métriques $\delta_b(n)=W_{S(b)}-MBA_b$ pour chacune des branches $B_b$ ($0 \leq b < NB$).

Si n<L-1 et si n n'est pas de la forme L0+k×L1-1, avec k entier supérieur ou égal à 1 (test 23), l'itération n dans la boucle principale se termine par le retour aux étapes 12 et 13.

Un parcours inverse est effectué dans le treillis lorsque le test 23 montre que n=L0+k×L1-1 (ou que n=L-1). Ce parcours inverse commence à l'étape 24 (figure 3B) par la sélection d'un état $E_{e0}$.

Si on n'a aucune connaissance a priori quant à l'état final, l'état sélectionné $E_{e0}$ est celui pour lequel la métrique d'état $W_{e0}$, accumulée jusqu'à l'itération n de la boucle principale, est maximale. A l'étape 25, des notes d'états $X_e$ sont respectivement prises égales aux différences $W_{e0}-W_e$ pour $0 \leq e < NE$, c'est-à-dire $X_e=M(\alpha_{opt})-Mx_e(n)$. Si l'état à la fin de la séquence est connu (par exemple parce que la séquence à détecter est suivie par une séquence de synchronisation connue), alors c'est cet état connu $E_{e0}$ qui est sélectionné à l'étape 24 lors de l'itération finale n=L-1, une note d'état nulle étant alors affectée à cet état $E_{e0}$ à l'étape 25, et des notes d'état arbitrairement grandes étant affectées aux autres états (ce qui revient à prendre $X_e = M(\alpha_{opt}) - MX_e(n)$ si des métriques élémentaires arbitrairement petites sont affectées aux branches conduisant à un état autre que $E_{e0}$ à la fin de la séquence).

Le parcours inverse dans le treillis comporte une seconde boucle, indexée par un entier r croissant de 0 à L0+L1-1. Dans chaque itération r de cette seconde boucle, on calcule une note de branche $Z_b$ égale à $M(\alpha_{opt}) - Mz_b(n-r)$ pour chaque branche $B_b$ ($0 \leq b < NB$), et, si r<L0+L1-1, on calcule de nouvelles notes d'état $Y_e$ respectivement égales à $M(\alpha_{opt}) - MX_e(n-r-1)$ pour l'itération suivante ($0 \leq e < NE$).

Dans l'itération r de cette seconde boucle, qui se rapporte à l'itération n-r de la boucle principale, la quantité $X_e$ désigne la note de l'état $E_e$ calculée à l'itération r-1 (ou initialisée à l'étape 25 si r=0), égale à $M(\alpha_{opt}) - Mx_e(n-r)$. Avant de procéder à une nouvelle itération dans cette seconde boucle (initialisation 26 par r=0, ou incrémentation de l'index r à l'étape 28), les notes d'état $X_e$ sont mises à jour à l'étape 25 ou 27. A l'étape 27, la mise à jour consiste simplement à prendre $X_e = Y_e$.

Dans chaque itération r de la boucle du parcours inverse, on commence par sélectionner la branche survivante $B_{b0}$ mémorisée pour l'état sélectionné $E_{e0}$, puis par sélectionner un nouvel état $E_{e0}$ correspondant à l'état de départ $E_{p(b0)}$ de la branche survivante sélectionnée (étapes 29 et 30). Des valeurs arbitrairement grandes (+∞) sont attribuées aux variables $Y_e$ ($0 \leq e < NE$), puis l'index de branche b est initialisé à 0 (étapes 31 et 32). Pour chaque valeur de b, la noce du branche $Z_b$ est calculée à l'étape 33 en lisant dans la mémoire la valeur de l'écart de métriques $\delta_b$ (n-r), et en ajoutant la valeur lue à la note $X_{S(b)}$ de l'état d'arrivée de la branche $B_b$. A l'étape 34, la variable $Y_{p(b)}$ est prise égale à la note de branche $Z_b$ si $Z_b$ est inférieure à la précédente valeur de cette variable $Y_{p(b)}$, et maintenue inchangée dans le cas contraire. L'index de branche b est ensuite comparé au nombre de branches NB dans le treillis à l'étape 35. Si b<NB-1, l'index de branche b est incrémenté à l'étape 36 avant de revenir à l'étape 33 pour le calcul de la prochaine note de branche. Quand b=NB-1 à l'étape 35, le calcul des notes de branche $Z_b$ et des nouvelles notes d'état $Y_e$ est terminé. Si r<L0 et n<L-1 (test 37), l'itération r dans la boucle du parcours inverse se termine par le retour aux étapes 27 et 28.

Sinon ($r \geq L_0$ ou n=L-1), on procède aux estimations des symboles de rangs m=Qx(n-r) à m=Q×(n-r+1)-1, et aux calculs de vraisemblance correspondants, comme représenté sur la figure 3C.

Pour chacun des Q symboles à estimer, repéré par l'index q ($0 \leq q < Q$, q étant initialisé à 0 à l'étape 39), la position m=Q× (n-r) +q est déterminée à l'étape 40, de même que l'index i de la valeur estimée $d^1$ du symbole $D_m$, donné par i=idec(b0,q), b0 étant l'index de la branche survivante sélectionnée à l'étape 29 précédente. Une note de décision $\Delta^j$ est initialisée à une valeur arbitrairement grande (+∞) pour chacune des décisions possibles $d^j$ ($0 \leq j < ND$), puis on initialise à 0 l'index de branche b (étapes 41 et 42). Pour chaque valeur de b, telle que la branche $B_b$ conduise à une décision $d^j$ pour le symbole de rang q (étape 43), la note de branche $Z_b$ est comparée à la variable $\Delta^j$ à l'étape 44. La variable $\Delta^j$ est mise à jour avec la note de branche $Z_b$ si cette note $Z_b$ est inférieure à la précédente valeur de cette variable $\Delta^j$, et maintenue inchangée sinon. A l'étape 45, l'index de branche b est comparé au nombre de branches NB du treillis: si b<NB-1, l'index de branche b est incrémenté à l'étape 46 avant de revenir à l'étape 43 pour le traitement de la prochaine branche. Quand b=NB-1 à l'étape 45, le calcul des notes de décision $\Delta^j$ est terminé, et on a $\Delta^i=0$ et, pour j≠i, $\Delta^j = M(\alpha_{opt}) - MD_q^j$ (n-r).

Le détecteur peut alors délivrer, à l'étape 47, l'estimation $\hat{D}_m = d^i$ du symbole $D_m$, ainsi que la vraisemblance associée $\Lambda_m$, égale à la plus petite des notes de décision $\Delta^j$ pour j≠i. Cette vraisemblance $\Lambda_m$ correspond à la différence de métriques minimale entre le chemin optimal $\alpha_{opt}$ et le "meilleur" chemin concurrent relativement au symbole $D_m$, telle que définie dans la relation (10).

Tant que tous les symboles relatifs à l'itération r du parcours inverse n'ont pas été estimés (q<Q-1 lors du test 48), on incrémente l'index q à l'étape 49 avant de revenir à l'étape 40. Quand q=Q-1 au test 48, l'index r est comparé à la profondeur du parcours inverse (test 50). Si r<L0+L1-1, l'itération r dans la boucle du parcours inverse se termine par le retour aux étapes 27 et 28.

Quand r=L0+L1-1, l'index n de l'itération dans la boucle principale est comparé à la longueur L de la séquence à l'étape 51. Si n<L-1, l'itération n se termine par le retour aux étapes 12 et 13. La procédure d'estimation des symboles de la séquence est achevée quand n=L-1 à l'étape 51.

On notera que la procédure d'estimation illustrée par la figure 3 se prête bien à diverses astuces de programmation permettant d'en simplifier ou d'en accélérer l'exécution. Par exemple, les traitements 16-19, 33-34 et 43-44 exécutés pour les différentes branches $B_b$ du treillis peuvent être totalement ou partiellement exécutés en parallèle. D'autre part, la régularité de la structure de beaucoup de treillis utilisables (comme par exemple ceux des figures 1 et 2) peut permettre de simplifier la procédure dans de nombreux cas.

Avantageusement, les écarts de métriques $\delta_b(n)$, qu'il est nécessaire de mémoriser, sont stockés dans une unité de mémoire organisée en mode dernier entré - premier sorti (LIFO). Ceci permet de simplifier largement, voire de supprimer, le mécanisme d'adressage dans cette unité de mémoire par l'organisme de calcul. En effet, on note que les écarts de métriques $\delta_b(n)$ sont lus dans la mémoire aux étapes 33 dans l'ordre inverse de celui dans lequel ils ont été écrits aux étapes 22. Il en est de même des identifications surv$_e$(n) des branches survivantes.

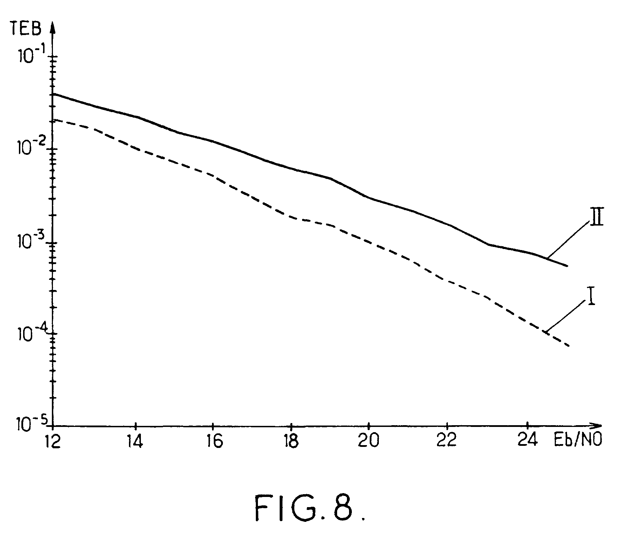

Les figures 4 et 5 illustrent la mise en oeuvre de l'invention dans un démodulateur de signal numérique.

La figure 4 montre schématiquement un émetteur de radiocommunication ayant à transmettre des symboles numériques a$_p$. Un codeur de canal 60 traite le flux numérique {a$_p$} conformément à un code à redondance dont les propriétés permettent la détection et/ou la correction d'erreurs de transmission. Une unité 61 effectue, de façon classique, un entrelacement des symboles délivrés par le codeur 60 afin d'améliorer les performances du code correcteur en présence d'erreurs de transmission survenant par paquets. Le modulateur 62 reçoit les symboles D$_m$ issus de l'unité d'entrelacement 61, ainsi qu'une séquence de synchronisation prédéfinie. Il est ainsi formé des trames successives de signal numérique influant chacune une ou plusieurs séquences de synchronisation et une ou plusieurs séquences de symboles d'information D$_m$.

A titre d'exemple, le modulateur 62 peut appliquer aux trames de signal une modulation à phase continue (CPM) quaternaire d'indice de modulation h=1/3, avec une impulsion de phase de durée égale à quatre temps symbole. Une telle modulation peut être décrite par un treillis tel que celui de la figure 1, lorsque l'impulsion de phase est modélisée comme limitée à son temps symbole central dans la conception du récepteur (voir B.E. RIMOLDI, "A Decomposition Approach to CPM", IEEE Trans. on Information Theory, Vol.34, No.2, mars 1988, pages 260-270).

Le signal de sortie du modulateur 62 est converti en analogique en 63, puis en un signal radio par un étage 64. Le signal radio ainsi émis est capté par un récepteur tel que celui représenté sur la figure 5, après avoir suivi un canal de propagation.

Le récepteur de la figure 5 comporte un étage radio 66 qui restitue, après les filtrages adéquats, un signal en bande de base, numérisé par un convertisseur 67. Le signal numérique en bande de base est un signal complexe fourni au démodulateur 68, qui comprend d'une part une unité 69 de synchronisation et d'estimation de canal, et d'autre part un processeur de Viterbi 70.

Sur la base des séquences de synchronisation introduites par l'émetteur dans les trames de signal, l'unité 69 fournit au processeur 70 l'information de synchronisation lui permettant de repérer les segments r$_n$ du signal numérique en bande de base formant le signal d'observation R utilisé dans le procédé selon l'invention. L'unité 69 procède également à une estimation de la réponse du canal afin de délivrer les signaux de référence S$_b$ utilisés dans la mise en oeuvre de l'algorithme de Viterbi. En l'absence d'interférence entre symboles, l'unité 69 estime simplement un nombre complexe représentant l'atténuation et la phase introduites par le canal, et le multiplie par des impulsions prédéfinies pour fournir les signaux de références s$_b$. S'il est tenu compte d'une interférence entre symboles, c'est une réponse impulsionnelle du canal qui est estimée par l'unité 69 et convoluée avec les impulsions prédéfinies pour former des signaux de référence S$_b$.

Le processeur de Viterbi 70 calcule les estimations $\hat{D}_m$ des symboles D$_m$ fournis au modulateur 62 de l'émetteur, et les vraisemblances correspondantes $\Lambda_m$ conformément au procédé exposé ci-dessus. Les métriques de branches élémentaires MB$_b$(n), calculées selon la convention produit scalaire, peuvent être produites par un banc de filtres adaptés 71 du processeur 70, recevant le signal en bande de base R et dont les coefficients sont définis par les signaux de référence s$_b$. Le processeur 70 comprend en outre une unité de traitement séquentiel 72 qui exécute les calculs selon l'algorithme de Viterbi à sorties souples (SOVA) précédemment décrit, et une unité de mémoire 73 de type LIFO, dans laquelle l'unité SOVA 72 écrit et lit les écarts de métriques $\delta_b$(n) et les indications surv$_e$ (n) des branches survivantes.

Avec la modulation CPM considérée, le procédé est exécuté avec ND=4, Q=1 si le codeur de canal 60 délivre des symboles quaternaires, et avec ND=2, Q=2 si les symboles de sortie du codeur de canal 60 sont des bits.

Comme symbolisé par la flèche *f* sur la figure 5, les symboles estimés par l'unité SOVA 72 peuvent être fournis en rétroaction à l'unité 69 d'estimation du canal, dans le cas où la variabilité du canal de propagation requiert qu'il soit estimé de manière adaptative.

En sortie du démodulateur 68, une unité de désentrelacement 75 opère la permutation de symboles inverse de celle effectuée par l'unité d'entrelacement 61 de l'émetteur, et délivre les estimations souples des symboles désentrelacés au décodeur de canal 76 dual du codeur 60. Le fait que ce décodeur 76 soit à entrées souples permet d'obtenir un gain appréciable en termes de taux d'erreurs dans les estimations â$_p$ des symboles ap transmis par l'émetteur. Le décodeur 76 peut être à sorties rigides. Il peut égalelement être à sorties souples (dans ce cas, il peut notamment mettre en oeuvre l'invention) si une information de vraisemblance est utile dans le traitement ultérieur des symboles décodés.

Les figures 6 et 7 illustrent une autre application de l'invention dans une chaîne de transmission numérique.

La figure 6 montre un émetteur de signal numérique comportant deux étages de codage. Un premier codeur 80, ou "codeur interne", reçoit les symboles a$_p$ à transmettre. Après un entrelacement par une unité 81, les symboles D$_m$ délivrés par le codeur interne 80 sont fournis à un second codeur 82, ou "codeur externe". Le flux de symboles délivrés par le codeur externe 82 est envoyé sur un canal de transmission qui peut être de nature quelconque (il peut notamment comprendre un modulateur, un canal de propagation et un démodulateur, par exemple comme décrit en référence aux figures 4 et 5 ; il peut également comprendre une mémoire dans laquelle l'information transmise serait stockée pendant une période plus ou moins longue).

Le codeur externe 82 traite le flux numérique $\{D_m\}$ conformément à un code à redondance dont les propriétés permettent la détection et/ou la correction d'erreurs de transmission. Le codeur interne 80 peut lui aussi être un codeur à redondance (les deux étages 80, 82 appliquent alors un code produit, ou turbocode).

A titre d'illustration, le codeur externe 82 peut fonctionner selon un code convolutif, qu'il est usuel de décoder au moyen de l'algorithme de Viterbi. C'est par exemple le code convolutif CC(2,1,3), de rendement 1/2 et de longueur de contrainte 3, auquel cas le treillis de décodage peut être celui représenté sur la figure 2.

Le récepteur représenté sur la figure 7 reçoit du canal de transmission le signal d'observation R distribué en segments successifs recouvrants $r_n$. Dans l'exemple évoqué du code convolutif CC(2,1,3), chaque segment $r_n$ couvre six bits du signal émis. Si le canal de transmission se termine par un démodulateur tel que le démodulateur 68 de la figure 5, chaque échantillon du signal d'observation R correspond à une valeur réelle dont le signe représente l'estimation d'un bit de sortie du codeur externe 82 et dont la valeur absolue correspond à la vraisemblance associée.

Le décodeur externe 84 du récepteur de la figure 7 comprend une unité 85 de calcul des métriques élémentaires $MB_b(n)$, une unité 86 de traitement séquentiel SOVA et une unité de mémoire 87 de type LIFO pour contenir les écarts de métriques $\delta_b(n)$ et les indications $surv_e(n)$ des branches survivantes. Chaque signal de référence $s_b$ consiste en six bits de valeur signée $\pm 1$ correspondant à deux bits associés à l'état de départ $E_{S(b)}$ et au bit associé à la branche $B_b$ (soit b mod 2). Ces six bits signés sont multipliés par les échantillons de chaque segment $r_n$ puis sommés par l'unité 85 pour fournir les métriques élémentaires $MB_b(n)$. L'unité SOVA 86 fonctionne de la manière précédemment décrite pour délivrer les estimations $\hat{D}_m$ des bits d'entrée $D_m$ du codeur externe 82, et les vraisemblances correspondantes $\Lambda_m$.

Ces estimations et vraisemblances sont désentrelacées par une unité 88 qui opère la permutation inverse de celle de l'unité 81 de l'émetteur. Le décodeur interne 89, dual du codeur interne 80, peut alors opérer le décodage requis, à décisions rigides ou souples $\hat{a}_p$, en bénéficiant de l'information de vraisemblance $\Lambda_m$ sur ses entrées souples. Il en résulte un gain sur le taux d'erreurs binaire global.

Dans une autre réalisation, le codeur interne 80 est un codeur de source. Dans ce cas, il traite non pas un flux de symboles $a_p$, mais un signal (audio, video...) à coder. C'est par exemple un codeur de parole. Le décodeur associé 89 pourra exploiter l'information de vraisemblance $\Lambda_m$ en fonction de la nature de l'information transportée par les bits concernés. Par exemple, pour certains paramètres d'un codeur de source, il peut être préférable d'effectuer une extrapolation sur la base de paramètres précédemment reçus plutôt que d'accepter une nouvelle valeur du paramètre associée à une vraisemblance faible.

La figure 8 montre des résultats obtenus en simulant un exemple de système de transmission selon les figures 4 et 5, dans lequel : le codeur de canal 60 applique un code convolutif CC(2,1,3) aux symboles binaires $a_p$; l'unité 61 applique un entrelacement par blocs de taille (20,14); le modulateur 62 applique une CPM quaternaire d'indice h=1/3; le démodulateur 68 estime des symboles quaternaires (ND=4, Q=1) en évaluant les vraisemblances selon la relation (10) à partir d'un treillis selon la figure 1; et le décodeur 76 fonctionne selon l'algorithme de Viterbi classique à entrées souples et sorties rigides. D'autre part, le démodulateur 68 opère deux démodulations, l'une du début de la trame vers la fin et l'autre de la fin de la trame vers le début, et le décodeur 76 assure les décodages des deux sériels d'estimations pondérées ainsi obtenues, pour sélectionner finalement le jeu symboles $\hat{a}_p$ qui fait l'objet du plus petit nombre de corrections d'erreurs sur la trame (cf. EP-A-0 821 500). Les courbes de la figure 8 ont été obtenues en simulant un canal de Rayleigh à évanouissements plats, avec une fréquence Doppler égale à $2,6 \times 10^{-3}$ fois la fréquence des symboles. La courbe I montre le taux d'erreur binaire (TEB) observé en fonction du rapport signal-sur-bruit Eb/N0 en mettant en oeuvre l'invention. La courbe II montre la même quantité obtenue dans le cas où les vraisemblances $\Lambda_m$ ne sont pas utilisées, le décodeur de canal 76 étant à entrées rigides. On note le gain appréciable procuré par l'invention, de l'ordre de 3 dB de rapport signal-sur-bruit pour un taux d'erreur binaire de $10^{-2}$, qui montre que les performances du procédé sont très proches de celles du MAP.

## Revendications

**1.** Procédé de détection d'une séquence de symboles discrets à partir d'un signal d'observation (R) dont la production peut être décrite à l'aide d'un treillis de NE états $E_e$, $0 \leq e < NE$, et NB branches $B_b$, $0 \leq b < NB$, chaque branche ayant un état de départ et un état d'arrivée parmi les NE états et étant associée à un unique Q-uplet de symboles discrets, Q étant un entier au moins égal à 1,

le treillis comportant des chemins formés chacun par une succession de branches, chaque chemin ayant une métrique définie par une somme de métriques élémentaires relatives aux branches successives qui le forment, et étant associé à une unique séquence possible de symboles discrets formée par la succession des Q-uplets auxquels sont respectivement associées les branches successives formant ledit chemin,

dans lequel le signal d'observation est traité par segments temporels successifs, le traitement effectué pour un segment n du signal d'observation comprenant :

- pour chacune des NB branches $B_b$, $0 \leq b < NB$, l'obtention d'une métrique élémentaire correspondant à une combinaison entre le segment n du signal d'observation et un signal de référence associé à la branche $B_b$, et le calcul d'une métrique de branche accumulée $MBA_b(n)$ en ajoutant la métrique élémentaire obtenue à une métrique d'état accumulée $MEA_e(n-1)$ relative à l'état de départ $E_e$ de la branche $B_b$; et

- pour chacun des NE états $E_e$, $0 \leq e < NE$, la mise à jour de la métrique d'état accumulée $MEA_e(n)$, prise égale à un optimum des métriques de branche accumulées $MBA_b(n)$ relatives à celles des branches $B_b$ qui ont l'état $E_e$ comme état d'arrivée, et la mémorisation d'une identification d'une branche survivante pour laquelle ledit optimum est atteint,

dans lequel, après avoir traité des segments successifs du signal d'observation, on sélectionne l'un des NE états $E_{e0}$ et un chemin optimal $\alpha_{opt}$ du treillis formé en remontant les branches survivantes depuis l'état sélectionné, et on estime au moins un symbole discret $D_m$ de la séquence à détecter par la valeur d'un symbole correspondant de la séquence à laquelle est associé le chemin optimal sélectionné,

et dans lequel on détermine une vraisemblance $\Lambda_m$ de l'estimation de chaque symbole $D_m$,

**caractérisé en ce que**, pour chaque symbole $D_m$ de la séquence à détecter, estimé après la sélection d'ur. état $E_{e0}$ et d'un chemin optimal $\alpha_{opt}$, on calcule une différence de métriques minimale entre le chemin optimal et un chemin concurrent associé à une séquence dont le symbole correspondant au symbole $D_m$ a une valeur autre que l'estimation retenue pour le symbole $D_m$, et on détermine la vraisemblance $\Lambda_m$ de l'estimation du symbole $D_m$ en fonction de la différence de métriques minimale calculée.

2. Procédé selon la revendication 1, dans lequel la vraisemblance $\Lambda_m$ de l'estimation du symbole $D_m$ est prise égale ou proportionnelle à la différence de métriques minimale calculée pour le symbole $D_m$.

3. Procédé selon la revendication 1 ou 2, dans lequel, le symbole $D_m$ ayant un nombre ND plus grand que deux de valeurs possibles $d^0,...,d^{ND-1}$, on calcule ND-1 différences de métriques relatives aux ND-1 valeurs possibles autres que l'estimation $d^i$ retenue pour le symbole $D_m$, la différence de métriques $\Delta^j$ relative à une valeur $d^j$, $0 \leq j < ND$, $j \neq i$, étant égale à la différence entre la métrique $M(\alpha_{opt})$ du chemin optimal et la métrique $MD_q^j(n)$ d'un chemin concurrent relatif à la valeur $d^j$, qui présente une métrique optimale parmi tous les chemins associés à des séquences dont le symbole correspondant au symbole $D_m$ a la valeur $d^J$, et la différence de métriques minimale pour le symbole $D_m$ est déterminée comme étant la plus petite des ND-1 différences de métriques relatives aux valeurs $d^j$, $0 \leq j < ND$, $j \neq i$.

4. Procédé selon la revendication 3, dans lequel la vraisemblances de l'estimation du symbole $D_m$ est prise égale ou proportionnelle à la différence de métriques minimale moins un terme dépendant de la dispersion des ND-1 différences de métriques relatives aux valeurs $d^j$, $0 \leq j < ND$, $j \neq i$.

5. Procédé selon l'une quelconque des revendications 1 à 4, dans lequel, lors des traitements effectués pour L0+L1 segments temporels successifs n-r du signal d'observation jusqu'à un segment n, n-L0-L1<n-r≤n, L0 étant un entier positif ou nul et L1 étant un entier strictement positif, on mémorise pour chaque branche b, $0 \leq b < NB$, l'écart $\delta_b(n-r) =) MBA_b(n-r) - MEA_e(n-r) |$ entre la métrique de branche accumulée $MBA_b(n-r)$ et la métrique d'état accumulée $MEA_e(n-r)$ mise à jour pour l'état d'arrivée $E_e$ de la branche $B_b$,

et dans lequel, après le traitement de L1 segments successifs du signal d'observation jusqu'à un segment n et la sélection d'un état $E_{e0}$, on procède à un calcul récursif sur la base des écarts de métriques mémorisés lors des traitements effectués pour les L0+L1 segments précédents n-r, n-L0-L1<n-r≤n, pour déterminer la différence de métriques minimale relativement à chaque symbole $D_m$ estimé à l'aide de la séquence à laquelle est associé le chemin optimal déterminé en remontant les branches survivantes depuis l'état sélectionné.

6. Procédé selon la revendication 5, dans lequel, après le traitement de L1 segments successifs du signal d'observation jusqu'à un segment n et la sélection d'un état, on estime QxL1 symboles $D_m$ relatifs aux L1 segments antérieurs n-r tels que n-L0-L1<n-r≤n-L0, et on détermine les vraisemblances respectives des estimations de ces QxL1 symboles $D_m$, les estimations de Q symboles relatifs à un segment antérieur n-r étant respectivement formées par les valeurs du Q-uplet de symboles auquel est associée la (r+1)-ième branche survivante du chemin optimal parcouru en remontant depuis l'état sélectionné.

7. Procédé selon la revendication 6, dans lequel, une fois qu'on a sélectionné un état $E_{e0}$ après le traitement de L1 segments successifs du signal d'observation jusqu'à un segment n, on initialise des notes d'état $X_e$ relatives aux NE états $E_e$, $0 \leq e < NE$, selon $X_e = |MEA_e(n) - MEA_{e0}(n)|$, puis on exécute les opérations suivantes pour chaque valeur de l'entier r allant de 0 à L0+L1-1 :

- la sélection de la branche survivante $B_{b0}$ mémorisée, pour l'état sélectionné $E_{e0}$, lors du traitement effectué pour le segment n-r, suivie par la mise à jour de l'état sélectionné $E_{e0}$ pris comme étant l'état de départ de la branche survivante sélectionnée $B_{b0}$ ;
- pour chacune des NB branches $B_b$, $0 \leq b < NB$, le calcul d'une note de branche $Z_b$ en ajoutant à la note d'état $X_e$ relative à l'état d'arrivée $E_e$ de la branche $B_b$ l'écart de métriques $\delta_b(n-r)$ mémorisé pour la branche $B_b$ ;
- pour chacun des NE états $E_e$, $0 \leq e < NE$, la mise à jour de la note d'état $X_e$, prise égale à la plus petite des notes de branche $Z_b$ calculées pour celles des branches $B_b$ qui ont l'état $E_e$ comme état de départ ;
- si $r \geq L0$, l'estimation de Q symboles de la séquence à détecter, par les valeurs du Q-uplet de symboles auquel est associée la branche survivante sélectionnée $B_{b0}$ ; et
- si $r \geq L0$, pour chaque estimation $d^i$ retenue pour l'un des Q symboles $D_m$, la détermination de la différence de métriques minimale comme étant la plus petite des notes de branche $Z_b$ calculées pour celles des branches $B_b$ qui sont associées à des Q-uplets dont le symbole correspondant au symbole $D_m$ a une valeur $d^J$ différente de l'estimation $d^l$.

8.  Procédé selon l'une quelconque des revendications 5 à 7, dans lequel les écarts de métriques $\delta_b(n-r)$ sont stockés dans des moyens de mémorisation organisés en mode dernier entré - premier sorti.

9.  Processeur de Viterbi, pour détecter une séquence de symboles discrets à partir d'un signal d'observation (R) dont la production peut être décrite à l'aide d'un treillis de NE états $E_e$, $0 \leq e < NE$, et NB branches $B_b$, $0 \leq b < NB$, chaque branche ayant un état de départ et un état d'arrivée parmi les NE états et étant associée à un unique Q-uplet de symboles discrets, Q étant un entier au moins égal à 1,

le treillis comportant des chemins formés chacun par une succession de branches, chaque chemin ayant une métrique définie par une somme de métriques élémentaires relatives aux branches successives qui le forment, et étant associé à une unique séquence possible de symboles discrets formée par la succession des Q-uplets auxquels sont respectivement associées les branches successives formant ledit chemin,

comprenant des moyens (71; 85) de calcul de métriques élémentaires, chaque métrique élémentaire $MB_b$(n) correspondant à une combinaison entre un segment temporel n du signal d'observation et un signal de référence associé à l'une des NB branches $B_b$, et des moyens (72; 86) de traitement séquentiel du signal d'observation par segments temporels successifs, agencés pour effectuer, pour chaque segment n du signal d'observation un traitement incluant :

- pour chacune des NB branches $B_b$, $0 \leq b < NB$, le calcul d'une métrique de branche accumulée $MBA_b$ (n) en ajoutant la métrique élémentaire $MB_b$ (n), fournie par les moyens de calcul de métriques élémentaires, à une métrique d'état accumulée $MEA_e$ (n-1) relative à l'état de départ $E_e$ de la branche $B_b$ ; et
- pour chacun des NE états $E_e$, $0 \leq e < NE$, la mise à jour de la métrique d'état accumulée $MEA_e$(n), prise égale à un optimum des métriques de branche accumulées $MBA_b$ (n) relatives à celles des branches $B_b$ qui ont l'état $E_e$ comme état d'arrivée, et la mémorisation d'une identification d'une branche survivante pour laquelle ledit optimum est atteint,

les moyens de traitement séquentiel étant agencés pour sélectionner l'un des NE états $E_{e0}$ et un chemin optimal $\alpha_{opt}$ du treillis après avoir traité des segments successifs du signal d'observation, le chemin optimal $\alpha_{opt}$ étant formé en remontant les branches survivantes depuis l'état sélectionné, pour estimer au moins un symbole discret $D_m$ de la séquence à détecter par la valeur d'un symbole correspondant de la séquence à laquelle est associé le chemin optimal sélectionné, et pour déterminer une vraisemblance $\Lambda_m$ de l'estimation de chaque symbole $D_m$,

**caractérisé en ce que** les moyens de traitement séquentiel sont agencés pour calculer, pour chaque symbole $D_m$ de la séquence à détecter, estimé après la sélection d'un état $E_{e0}$ et d'un chemin optimal $\alpha_{opt}$, une différence de métriques minimale entre le chemin optimal et un chemin concurrent associé à une séquence dont le symbole correspondant au symbole $D_m$ a une valeur autre que l'estimation retenue pour le symbole $D_m$, et pour déterminer la vraisemblance $\Lambda_m$ de l'estimation du symbole $D_m$ en fonction de la différence de métriques minimale calculée.

10.  Processeur de Viterbi selon la revendication 9, dans lequel les moyens de traitement séquentiel (72; 86) déterminent la vraisemblance $\Lambda_m$ de l'estimation du symbole $D_m$ comme étant égale ou proportionnelle à la différence de métriques minimale calculée pour le symbole $D_m$.

11.  Processeur de Viterbi selon la revendication 9 ou 10, comprenant des moyens de mémorisation (73; 87) dans lesquels les moyens de traitement séquentiel (72; 86) enregistrent pour chacune des NB branches $B_b$, $0 \leq b < NB$,

lors des traitements effectués pour L0+L1 segments temporels successifs n-r du signal d'observation jusqu'à un segment n, n-L0-L1<n-r≤n, l'écart $\delta_b(n-r)=|MBA_b(n-r)-MEA_e(n-r)|$ entre la métrique de branche accumulée $MBA_b$ (n-r) et la métrique d'état accumulée $MEA_e(n-r)$ mise à jour pour l'état d'arrivée $E_e$ de la branche $B_b$, L0 étant un entier positif ou nul et L1 étant un entier strictement positif,

et dans lequel les moyens de traitement séquentiel sont agencés pour procéder, après le traitement de L1 segments successifs du signal d'observation jusqu'à un segment n et la sélection d'un état $E_{e0}$, à un calcul récursif sur la base des écarts de métriques enregistrés dans les moyens de mémorisation, afin de déterminer la différence de métriques minimale relativement à chaque symbole $D_m$ estimé à l'aide de la séquence à laquelle est associé le chemin optimal déterminé en remontant les branches survivantes depuis l'état sélectionné.

**12.** Processeur de Viterbi selon la revendication 11, dans lequel, après le traitement de L1 segments successifs du signal d'observation jusqu'à un segment n et la sélection d'un état, les moyens de traitement séquentiel estiment $Q{\times}L1$ symboles $D_m$ relatifs aux L1 segments antérieurs n-r tels que n-L0-L1<n-r≤n-L0, et déterminent les vraisemblances respectives des estimations de ces $Q{\times}L1$ symboles $D_m$, les estimations de Q symboles relatifs à un segment antérieur n-r étant respectivement formées par les valeurs du Q-uplet de symboles auquel est associée la (r+1)-ième branche survivante du chemin optimal parcouru en remontant depuis l'état sélectionné.

**13.** Processeur de Viterbi selon la revendication 12, dans lequel, une fois qu'ils ont sélectionné un état $E_{e0}$ après le traitement de L1 segments successifs du signal d'observation jusqu'à un segment n, les moyens de traitement séquentiel (72; 86) initialisent des notes d'état $X_e$ relatives aux NE états $E_e$, 0≤e<NE, selon $X_e=|MEA_e(n)-MEA_{e0}$ (n)|, puis exécutent les opérations suivantes pour chaque valeur de l'entier r allant de 0 à L0+L1-1 :

-   la sélection de la branche survivante $B_{b0}$ mémorisée, pour l'état sélectionné $E_{e0}$, lors du traitement effectué pour le segment n-r, suivie par la mise à jour de l'état sélectionné $E_{e0}$ pris comme étant l'état de départ de la branche survivante sélectionnée $B_{b0}$ ;
-   pour chacune des NB branches $B_b$, 0≤b<NB, le calcul d'une note de branche $Z_b$ en ajoutant à la note d'état $X_e$ relative à l'état d'arrivée $E_e$ de la branche $B_b$ l'écart de métriques $\delta_b(n-r)$ mémorisé pour la branche $B_b$ ;
-   pour chacun des NE états $E_e$, 0≤e<NE, la mise à jour de la note d'état $X_e$, prise égale à la plus petite des notes de branche $Z_b$ calculées pour celles des branches $B_b$ qui ont l'état $E_e$ comme état de départ ;
-   si r≥L0, l'estimation de Q symboles de la séquence à détecter, par les valeurs du Q-uplet de symboles auquel est associée la a branche survivante sélectionnée $B_{b0}$ ; et
-   si r≥L0, pour chaque estimation $d^i$ retenue pour l'un des Q symboles $D_m$, la détermination de la différence de métriques minimale comme étant la plus petite des notes de branche $Z_b$ calculées pour celles des branches $B_b$ qui sont associées à des Q-uplets dont le symbole correspondant au symbole $D_m$ a une valeur $d^j$ différente de l'estimation $d^i$.

**14.** Processeur de Viterbi selon l'une quelconque des revendications 11 à 13, dans lequel les moyens de mémorisation (73; 87) sont organisés en mode dernier entré - premier sorti.

**15.** Démodulateur de signal numérique, comprenant des moyens d'estimation de canal (69) pour déterminer, à partir d'un signal d'observation (R), des signaux de référence ($S_b$) respectivement associés à NB branches ($B_b$) d'un treillis, et un processeur de Viterbi (70) selon l'une quelconque des revendications 9 à 14, recevant les signaux de référence et le signal d'observation distribué en segments successifs ($r_n$), et produisant des estimations ($D_m$) de symboles discrets traités par un modulateur (62) et des vraisemblances ($\Lambda_m$) respectivement associées à ces estimations.

**16.** Décodeur de signal numérique, comprenant un processeur de Viterbi (84) selon l'une quelconque des revendications 9 à 14, recevant un signal d'observation (R) distribué en segments successifs ($r_n$), et produisant des estimations ($D_m$) de symboles discrets traités par un codeur (82) et des vraisemblances ($\Lambda_m$) respectivement associées à ces estimations.

**Claims**

**1.** A method for detecting a discrete symbol sequence from an observation signal (R) the production of which can be described by means of a trellis of NE states $E_e$, 0≤e<NE, and NB branches $B_b$, 0≤b<NB, each branch having a start state and an arrival state among the NE states and being associated with a single Q-uplet of discrete symbols, Q being an integer at least equal to 1,

the trellis comprising paths each formed by a succession of branches, each path having a metric defined by a sum of elementary metrics relative to the successive branches which form it, and being associated with a single possible sequence of discrete symbols formed by the succession of Q-uplets with which the successive branches forming said path are respectively associated,

wherein the observation signal is processed by successive time segments, the processing of a segment n of the observation signal including:

- for each of the NB branches $B_b$, $0 \leq b < NB$, obtaining an elementary metric corresponding to a combination between the segment n of the observation signal and a reference signal associated with the branch $B_b$, and the calculation of an accumulated branch metric $MBA_b(n)$ by adding the elementary metric obtained to an accumulated state metric $MEA_e(n-1)$ relative to the start state $E_e$ of the branch $B_b$ ; and
- for each of the NE states $E_e$, $0 \leq e < NE$, updating the accumulated state metric $MEA_e(n)$, taken as equal to an optimum of the accumulated branch metrics $MBA_b(n)$ relative to those of the branches $B_b$ which have the state $E_e$ as the arrival state, and storing an identification of a surviving branch for which said optimum is reached,

wherein, after processing successive segments of the observation signal, a selection is made of one of the NE states $E_{e0}$ and of an optimal path $\alpha_{opt}$ of the trellis formed by returning up the surviving branches from the selected state, and at least one discrete symbol $D_m$ of the sequence to be detected is estimated by the value of a corresponding symbol of the sequence with which the selected optimal path is associated,

and wherein, a likelihood $\Lambda_m$ of the estimation of each symbol $D_m$ is determined,

**characterised in that**, for each symbol $D_m$ of the sequence to be detected, estimated after the selection of a state $E_{e0}$ and of an optimal path $\alpha_{opt}$, a minimum difference in metrics is calculated between the optimal path and a competitor path associated with a sequence in which the symbol corresponding to the symbol $D_m$ has a value other than the estimation retained for the symbol $D_m$, and the likelihood $\Lambda_m$ of the estimation of the symbol $D_m$ is determined as a function of the calculated minimum difference in metrics.

2. A method according to claim 1, wherein the likelihood $\Lambda_m$ of the estimation of the symbol $D_m$ is taken as equal or proportional to the minimum difference in metrics calculated for the symbol $D_m$.

3. A method according to claim 1 or 2, wherein, the symbol $D_m$ having a number ND greater than two of possible values $d^0,....,d^{ND-1}$, ND-1 differences in metrics are calculated relative to the NO-1 possible values other than the estimation $d^i$ retained for the symbol $D_m$, the difference in metrics $\Delta^j$ relative to a value $d^j$, $0 \leq j < ND$, $j \neq i$, being equal to the difference between the metric $M(\alpha_{opt})$ of the optimal path and the metric $MD_q^j(n)$ of a competitor path relative to the value $d^j$, which offers an optimal metric among all the paths associated with sequences in which the symbol corresponding to the symbol $D_m$ has the value $d^j$, and the minimum difference in metrics for the symbol $D_m$ is determined as being the smallest of the ND-1 differences in metrics relative to the values $d^j$, $0 \leq j < ND$, $j \neq i$.

4. A method according to claim 3, wherein the likelihood $\Lambda_m$ of the estimation of the symbol $D_m$ is taken as equal or proportional to the minimum difference in metrics less a term dependent on the dispersion of the ND-1 differences in metrics relative to the values $d^j$, $0 \leq j < ND$, $j \neq i$.

5. A method according to any one of claims 1 to 4, wherein, during the processing of L0+L1 successive time segments n-r of the observation signal up to a segment n, $n-L0-L1 < n-r \leq n$, L0 being a positive or zero integer and L1 being a strictly positive integer, for each branch b ($0 \leq b < NB$) is stored the difference $\delta_b(n-r)=|MBA_b(n-r)-MEA_e(n-r)|$ between the accumulated branch metric $MBA_b(n-r)$ and the accumulated state metric $MEA_e(n-r)$ updated for the arrival state $E_e$ of the branch $B_b$.

and wherein, after the processing of L1 successive segments of the observation signal up to a segment n and the selection of a state $E_{e0}$, a recursive calculation is made on the basis of the differences in metrics stored during the processing of the previous L0+L1 segments n-r, $n-L0-L1 < n-r \leq n$, in order to determine the minimum difference in metrics relative to each symbol $D_m$ estimated by means of the sequence with which is associated the optimal path determined by returning up the surviving branches from the selected state.

6. A method according to claim 5, wherein, after the processing of L1 successive segments of the observation signal up to a segment n and the selection of a state, $QxL1$ symbols $D_m$ are estimated relative to the previous L1 segments n-r such that $n-L0-L1 < n-r \leq n-L0$, and the respective likelihoods of the estimations of these $QxL1$ symbols $D_m$ are determined, the estimations of Q symbols relative to a previous segment n-r being formed respectively by the values of the Q-uplet of symbols with which is associated the (r+1)-th surviving branch of the optimal path covered by returning up from the selected state.

7. A method according to claim 6, wherein, once a state $E_{e0}$ has been selected after the processing of L1 successive segments of the observation signal up to a segment n, state notes $X_e$ relative to the NE states $E_e$, $0 \leq e < NE$, are initialised according to $X_e = |MEA_e(n) - MEA_{e0}(n)|$, then the following operations are performed for each value of the integer r ranging from 0 to L0+L1-1:

- the selection of the surviving branch $B_{b0}$ stored, for the selected state $E_{e0}$, during the processing of the segment n-r, followed by the updating of the selected state $E_{e0}$ taken as being the start state of the surviving branch selected $B_{b0}$ ;
- for each of the NB branches $B_b$, $0 \leq b < NB$, the calculation of a branch note $Z_b$ by adding to the state note $X_e$ relative to the arrival state $E_e$ of the branch $B_b$ the difference in metrics $\delta_b(n-r)$ stored for the branch $B_b$;
- for each of the NE states $E_e$, $0 \leq e < NE$, the updating of the state note $X_e$, taken as equal to the smallest of the branch notes $Z_b$ calculated for those of the branches $B_b$ which have the state $E_e$ as the start state;
- if $r \geq L0$, the estimation of Q symbols of the sequence to be detected, by the values of the Q-uplet of symbols with which the surviving branch selected $B_{b0}$ is associated; and
- if $r \geq L0$, for each estimation $d^i$ accepted for one of the Q symbols $D_m$, the determination of the minimum difference in metrics as being the smallest of the branch notes $Z_b$ calculated for those of the branches $B_b$ which are associated with Q-uplets in which the symbol corresponding to the symbol $D_m$ has a value $d^j$ different from the estimation $d^i$.

8. A method according to any one of claims 5 to 7, wherein the differences in metrics $\delta_b(n-r)$ are stored in storage means in last in - first out mode.

9. A Viterbi processor, for detecting a discrete symbol sequence from an observation signal (R) the production of which can be described by means of a trellis of NE states $E_e$, $0 \leq e < NE$, and NB branches $B_b$, $0 \leq b < NB$, each branch having a start state and an arrival state among the NE states and being associated with a single Q-uplet of discrete symbols, Q being an integer at least equal to 1,

the trellis comprising paths each formed by a succession of branches, each path having a metric defined by a sum of elementary metrics relative to the successive branches which form it, and being associated with a single possible sequence of discrete symbols formed by the succession of Q-uplets with which the successive branches forming said path are respectively associated,

including elementary metrics calculation means (71; 85) for calculating elementary metrics $MB_b(n)$ each corresponding to a combination between a time segment n of the observation signal and a reference signal associated with one of the NB branches $B_b$, and sequential processing means (72; 86) for processing the observation signal by successive time segments, arranged to carry out, for each segment n of the observation signal, a processing including:

- for each of the NB branches $B_b$, $0 \leq b < NB$, the calculation of an accumulated branch metric $MBA_b(n)$ by adding the elementary metric $MB_b(n)$, provided by the elementary metrics calculation means to an accumulated state metric $MEA_e(n-1)$ relative to the start state $E_e$ of the branch $B_b$ ; and
- for each of the NE states $E_e$, $0 \leq e < NE$, the updating of the accumulated state metric $MEA_e(n)$, taken as equal to an optimum of the accumulated branch metrics $MBA_b(n)$ relative to those of the branches $B_b$ which have the state $E_e$ as the arrival state, and the storage of an identification of a surviving branch for which said optimum is reached,

the sequential processing means being arranged to select one of the NE states $E_{e0}$ and an optimal path $\alpha_{opt}$ of the trellis after processing successive segments of the observation signal, the optimal path $\alpha_{opt}$ being formed by returning up the surviving branches from the selected state, in order to estimate at least one discrete symbol $D_m$ of the sequence to be detected by the value of a corresponding symbol of the sequence with which the selected optimal path is associated, and to determine a likelihood $A_m$ of the estimation of each symbol $D_m$ ,
**characterised in that** the sequential processing means are arranged to calculate, for each symbol $D_m$ of the sequence to be detected, estimated after the selection of a state $E_{e0}$ and an optimal path $\alpha_{opt}$, a minimum difference in metrics between the optimal path and a competitor path associated with a sequence of which the symbol corresponding to the symbol $D_m$ has a value other than the estimation retained for the symbol $D_m$, and to determine the likelihood $\Lambda_m$ of the estimation of the symbol $D_m$ as a function of the calculated minimum difference in metrics.

10. A Viterbi processor according to claim 9, wherein the sequential processing means (72; 86) determines the likelihood $\Lambda_m$ of the estimation of the symbol $D_m$ as being equal or proportional to the minimum difference in metrics calculated for the symbol $D_m$.

**11.** A Viterbi processor according to claim 9 or 10, including storage means (73; 87) into which the sequential processing means (72; 86) enter for each of the NB branches $B_b$, $0 \leq b < NB$, during the processing of L0+L1 successive time segments n-r of the observation signal up to a segment n, n-L0-L1<n-r≤n, the difference $\delta_b(n-r)=|MBA_b(n-r)-MEA_e(n-r)|$ between the accumulated branch metric $MBA_b(n-r)$ and the accumulated state metric $MEA_e(n-r)$ updated for the arrival state $E_e$ of the branch $B_b$, L0 being a positive or zero integer and L1 being a strictly positive integer,

and wherein the sequential processing means are arranged so as to make, after the processing of L1 successive segments of the observation signal up to a segment n and the selection of a state $E_{e0}$, a recursive calculation on the basis of the difference in metrics entered in the storage means, in order to determine the minimum difference in metrics relative to each symbol $D_m$ estimated by means of the sequence with which is associated the optimal path determined by returning up the surviving branches from the selected state.

**12.** A Viterbi processor according to claim 11, wherein, after the processing of L1 successive segments of the observation signal up to a segment n and the selection of a state, the sequential processing means estimate QxL1 symbols $D_m$ relative to the previous L1 segments n-r such that n-L0-L1 <n-r≤n-L0, and determine the respective likelihoods of the estimations of these QxL1 symbols $D_m$, the estimations of Q symbols relative to a previous segment n-r being formed respectively by the values of the Q-uplet of symbols with which is associated the (r+1)-th surviving branch of the optimal path covered by returning up from the selected state.

**13.** A Viterbi processor according to claim 12, wherein, once they have selected a state $E_{e0}$ after the processing of L1 successive segments of the observation signal up to a segment n, the sequential processing means (72; 86) initialise state notes $X_e$ relative to the NE states $E_e$ ($0 \leq e < NE$) according to $X_e=|MEA_e(n)-MEA_{e0}(n)|$, then perform the following operations for each value of the integer r ranging from 0 to L0+L1-1:

- the selection of the surviving branch $B_{b0}$ stored, for the selected state $E_{e0}$, during the processing of the segment n-r, followed by the updating of the selected state $E_{e0}$ taken as being the start state of the surviving branch selected $B_{b0}$ ;
- for each of the NB branches $B_b$, $0 \leq b < NB$, the calculation of a branch note $Z_b$ by adding to the state note $X_e$ relative to the arrival state $E_e$ of the branch $B_b$ the difference in metrics $\delta_b(n-r)$ stored for the branch $B_b$;
- for each of the NE states $E_e$, $0 \leq e < NE$, the updating of the state note $X_e$, taken as equal to the smallest of the branch notes $Z_b$ calculated for those of the branches $B_b$ which have the state Eg as the start state;
- if r≥L0, the estimation of Q symbols of the sequence to be detected, by the values of the Q-uplet of symbols with which the surviving branch selected $B_{b0}$ is associated; and
- if r≥L0, for each estimation $d^i$ accepted for one of the Q symbols $D_m$, the determination of the minimum difference in metrics as being the smallest of the branch notes $Z_b$ calculated for those of the branches $B_b$ which are associated with Q-uplets the symbol of which corresponding to the symbol $D_m$ has a value $d^j$ different from the estimation $d^i$.

**14.** A Viterbi processor according to any one of claims 11 to 13, wherein the storage means (73; 87) are organised in last-in - first out mode.

**15.** A digital signal demodulator, including channel estimation means (69) to determine, from an observation signal (R), reference signals ($s_b$) respectively associated with NB branches ($B_b$) of a trellis, and a Viterbi processor (70) according to any one of claims 9 to 14, receiving the reference signals and the observation signal distributed in successive segments ($r_n$), and producing estimations ($D_m$) of discrete symbols processed by a modulator (62) and likelihoods ($\Lambda_m$) respectively associated with these estimations.

**16.** A digital signal decoder, including a Viterbi processor (84) according to any one of claims 9 to 14, receiving an observation signal (R) distributed in successive segments ($r_n$), and producing estimations ($D_m$) of discrete symbols processed by an encoder (82) and likelihoods ($\Lambda_m$) respectively associated with these estimations.

**Patentansprüche**

**1.** Verfahren zum Detektieren einer Folge diskreter Symbole aus einem Messsignal (R), dessen Erzeugung mit Hilfe eines Gitters aus NE Zuständen $E_e$, $0 \leq e < NE$, und NB Abschnitten $B_b$, $0 \leq b < NB$, beschreibbar ist, wobei jeder Abschnitt einen Ausgangszustand und einen Zielzustand unter den NE Zuständen aufweist und dabei einem einzigen Q-Plett von diskreten Symbolen zugeordnet ist, wobei Q eine ganze Zahl ist, die mindestens gleich 1 ist,

wobei das Gitter Pfade aufweist, die jeweils aus einer Abfolge von Abschnitten gebildet sind,

wobei jeder Pfad eine Metrik aufweist, die durch eine Summe von sich auf die aufeinander folgenden Abschnitte, die ihn bilden, beziehenden elementaren Metriken definiert ist und einer einzigen möglichen Folge von diskreten Symbolen zugeordnet ist, die durch die Abfolge der Q-Pletts gebildet wird, denen jeweils die den Pfad bildenden aufeinander folgenden Abschnitte zugeordnet sind,

bei welchem das Messsignal durch aufeinander folgende zeitliche Segmente bearbeitet wird, wobei die für ein Segment n des Messsignals vorgenommene Bearbeitung folgendes aufweist:

- für jeden der NB Abschnitte $B_b$, $0 \leq b < NB$: Erhalten einer elementaren Metrik, die einer Kombination aus dem Segment n des Messsignals und aus einem dem Abschnitt $B_b$ zugeordneten Referenzsignal entspricht, und Berechnen einer akkumulierten Abschnittsmetrik $MBA_b(n)$, indem die erhaltene elementare Metrik zu einer akkumulierten Zustandsmetrik $MEA_e(n-1)$ hinzugefügt wird, die sich auf den Ausgangszustand $E_e$ des Abschnitts $B_b$ bezieht; und
- für jeden der NE Zustände $E_e$, $0 \leq e < NE$: Aktualisieren der akkumulierten Zustandsmetrik $MEA_e(n)$, die gleich einem Optimum der akkumulierten Abschnittsmetriken $MBA_b(n)$ angesetzt wird, die jene unter den Abschnitten $B_b$ betreffen, die den Zustand $E_e$ als Zielzustand aufweisen, und Abspeichern einer Kennung eines verbliebenen Abschnitts, für den das Optimum erreicht ist,

bei welchem nach der Bearbeitung der aufeinander folgenden Segmente des Messsignals einer der NE Zustände $E_{e0}$ und ein optimaler Pfad $\alpha_{opt}$ des Gitters gewählt werden, der dadurch gebildet wird, dass die verbliebenen Abschnitte vom gewählten Zustand aus wieder zusammengebaut werden, und mindestens ein diskretes Symbol $D_m$ aus der zu erfassenden Abfolge anhand des Werts eines Symbols abgeschätzt wird, welches der Abfolge entspricht, der der gewählte optimale Pfad zugeordnet ist,

und bei welchem eine Wahrscheinlichkeit $\Lambda_m$ der Abschätzung jedes Symbols $D_m$ ermittelt wird,

**dadurch gekennzeichnet, dass** für jedes Symbol $D_m$ der zu detektierenden Folge bewertet nach Auswahl eines Zustands $E_{e0}$ und eines optimalen Pfads $\alpha_{opt}$ eine kleinstmögliche Differenz der Metriken zwischen dem optimalen Pfad und einem konkurrierenden Pfad berechnet wird, der einer Folge zugeordnet ist, deren dem Symbol $D_m$ entsprechendes Symbol einen anderen Wert als die für das Symbol $D_m$ erhaltene Abschätzung aufweist, und dass die Wahrscheinlichkeit Am der Abschätzung des Symbols $D_m$ in Abhängigkeit von der berechneten minimalen Differenz der Metriken bestimmt wird.

2. Verfahren nach Anspruch 1, bei dem die Wahrscheinlichkeit Am bei der Abschätzung des Symbols $D_m$ gleich der oder proportional zu der für das Symbol $D_m$ berechneten minimalen Differenz der Metriken angesetzt wird.

3. Verfahren nach Anspruch 1 oder 2, bei dem, wenn das Symbol $D_m$ eine Zahl ND aufweist, die größer ist als zwei der möglichen Werte $d^0$, ..., $d^{ND-1}$, ND-1 Metrikdifferenzen berechnet werden, die sich auf ND-1 mögliche sich von der Abschätzung d' unterscheidende für das Symbol $D_m$ erhaltene Werte beziehen, die Metrikdifferenz $\Delta^j$, die sich auf einen Wert $d^j$, $0 \leq j < ND$; $j \neq i$, bezieht, gleich der Differenz zwischen der Metrik $M(\alpha_{opt})$ des optimalen Pfads und der Metrik $MD^j_q(n)$ eines konkurrierenden sich auf den Wert $d^j$ beziehenden Pfads ist, der eine optimale Metrik unter all den Pfaden zeigt, die Folgen zugeordnet sind, deren dem Symbol $D_m$ entsprechendes Symbol den Wert $d^j$ aufweist, und die minimale Differenz der Metriken für das Symbol $D_m$ derart bestimmt ist, dass sie die kleinste der ND-1 die Werte $d^j$ , $0 \leq j < ND$, j # i, betreffenden Metrikdifferenzen ist.

4. Verfahren nach Anspruch 3, bei welchem die Wahrscheinlichkeit $\Lambda_m$ der Abschätzung des Symbols $D_m$ gleich oder proportional zu der minimalen Metrikdifferenz verringert um einen Term angesetzt wird, der von der Streuung der ND-1 Metrikdifferenzen abhängig ist, die sich auf die Werte $d^j$, $0 \leq j < ND$, $j \neq i$, beziehen.

5. Verfahren nach einem der Ansprüche 1 bis 4, bei dem
während der Bearbeitungen, die für L0+L1 aufeinander folgende zeitliche Segmente n-r des Messsignals bis zu einem Segment n, n-L0-L1 < n-r ≤ n, vorgenommen werden, wobei L0 eine positive ganze Zahl oder Null ist und L1 eine streng positive ganze Zahl ist, für jeden Abschnitt b, $0 \leq b < NB$, der Abstand $\delta_b(n-r) = |MBA_b(n-r) - MEA_e(n-r)|$ zwischen der akkumulierten Abschnittsmetrik des $MBA_b(n-r)$ und der akkumulierten Zustandsmetrik des $MEA_e(n-r)$ abgespeichert wird, der für den Zielzustand $E_e$ des Abschnitts $B_b$ aktualisiert wurde,
und bei welchem nach der Bearbeitung der L1 aufeinander folgenden Segmente des Messsignals bis zu einem Segment n und bis zur Auswahl eines Zustands $E_{e0}$ mit einer rekursiven Berechnung auf der Grundlage der Metrikabstände gearbeitet wird, die während der Bearbeitungsgänge abgespeichert wurden, die für die L0+L1 vorhergehenden Segmente n-r, n-L0-L1 < n-r $\leq$ n, gespeichert wurden, um die kleinstmögliche Metrikdifferenz relativ zu jedem Symbol $D_m$ zu bestimmen, das mit Hilfe der Folge abgesdchätzt wurde, welcher der optimale Pfad zugeordnet ist, welcher durch erneutes Zusammenfügen der seit dem ausgewählten Zustand verbliebenen Abschnitte bestimmt ist.

**6.** Verfahren nach Anspruch 5, bei welchem nach der Bearbeitung von L1 aufeinander folgenden Segmenten des Messsignals bis zu einem Segment n und der Auswahl eines Zustands QxL1 Symbole $D_m$ hochgerechnet werden, die sich auf L1 vorhergehende Segmente n-r wie zum Beispiel n-L0-L1 < n-r $\leq$ n-L0 beziehen, und die jeweiligen Wahrscheinlichkeiten der Hochrechnungen dieser QxL1 Symbole $D_m$ bestimmt werden, wobei die Hochrechnungen von Q Symbolen, die sich auf ein vorhergehendes Segment n-r beziehen, jeweils durch die Werte des Q-Pletts der Symbole gebildet werden, denen der (r+1)-te verbliebene Abschnitt des optimalen Pfads zugeordnet ist, der durch erneutes Zusammenfügen seit dem ausgewählten Zustand durchlaufen wurde.

**7.** Verfahren nach Anspruch 6, bei welchem, sobald ein Zustand $E_{e0}$ nach der Bearbeitung der L1 aufeinander folgenden Segmente des Messsignals bis zu einem Segment n gewählt wurde, Zustandshinweise $X_e$, die sich auf NE Zustände $E_e$, 0 $\leq$ e < NE, beziehen, gemäß der Beziehung $X_e$ = |$MEA_e(n)$ - $MEAeo(n)$ |initialisiert werden und dann für jeden Wert der ganzen Zahl r, die von 0 bis L0+L1-1 geht, die folgenden Operationen ausgeführt werden:

- die Auswahl des gespeicherten verbliebenen Abschnitts $B_{b0}$ für den ausgewählten Zustand $E_{e0}$ während der Bearbeitung, die für den Abschnitt n-r ausgeführt wird, woran sich die Aktualisierung des ausgewählten Zustands $E_{e0}$ anschließt, der so angesetzt wird, als sei er der Ausgangszustand des ausgewählten verbliebenen Abschnitts $B_{bc}$;
- für jeden der NB Abschnitte $B_b$, 0 $\leq$ b < NB: die Berechnung eines Abschnittshinweises $Z_b$, indem dem Zustandshinweis $X_e$, der sich auf den Zielzustand $E_e$ des Abschnitts $B_b$ bezieht, der Abstand der Metriken $\delta_b$(n-r) hinzugefügt wird, der für den Abschnitts $B_b$ gespeichert wurde;
- für jeden der NE Zustände $E_e$, 0 $\leq$ e < NE: die Aktualisierung des Zustandshinweises $X_e$, der gleich dem kleinsten der Abschnittshinweise $Z_b$ angesetzt wird, welche für jene Abschnitte $B_b$ berechnet wurden, die den Zustand $E_e$ als Ausgangszustand besitzen;
- wenn r $\geq$ L0 ist: die Hochrechnung von Q Symbolen der zu detektierenden Abfolge anhand der Werte des Q-Pletts der Symbole, dem der ausgewählte verbliebene Abschnitt $B_{b0}$ zugeordnet ist; und
- wenn r $\geq$ L0 ist: für jede Hochrechnung d', die man für eines der Q Symbole $D_m$ erhalten hat, die Bestimmung der kleinstmöglichen Differenz der Metriken als den kleinsten der Abschnittshinweise $Z_b$, die für jeden der Abschnitte $B_b$ berechnet wurden, welche Q-Pletts zugeordnet sind, deren dem Symbol $D_m$ entsprechendes Symbol einen Wert $d^j$ besitzt, der sich von der Hochrechnung d' unterscheidet.

**8.** Verfahren nach einem der Ansprüche 5 bis 7, bei welchem die Abstände der Metriken $\delta_b$(n-r) in Speichereinrichtungen abgespeichert werden, die nach dem LIFO-Modus ("last in - first out") organisiert sind.

**9.** Viterbi-Prozessor zum Erfassen einer Folge diskreter Symbole aus einem Messsignal (R), dessen Erzeugung mit Hilfe eines Gitters aus NE Zuständen $E_e$, 0 $\leq$ e < NE, und NB Abschnitten $B_b$, 0 $\leq$ b < NB, beschreibbar ist, wobei jeder Abschnitt einen Ausgangszustand und einen Zielzustand unter den NE Zuständen besitzt und dabei einem einzigen Q-Plett von diskreten Symbolen zugeordnet ist, wobei Q eine ganze Zahl ist, die mindestens gleich 1 ist, wobei das Gitter Pfade aufweist, die jeweils aus einer Abfolge von Abschnitten gebildet sind, wobei jeder Pfad eine Metrik besitzt, die durch eine Summe von elementaren Metriken definiert ist, die sich auf die aufeinander folgenden Abschnitte beziehen, welche den Pfad bilden, und wobei jeder Pfad einer einzigen möglichen Abfolge von diskreten Symbolen zugeordnet ist, welche durch die Abfolge der Q-Plett gebildet wird, denen jeweils die aufeinander folgenden Abschnitte zugeordnet sind, welche den Pfad bilden, welcher Recheneinrichtungen (71; 85) zum Berechnen der elementaren Metriken aufweist, wobei jede elementare Metrik $MB_b(n)$ einer Kombination aus einem zeitlichen Segment n des Messsignals und aus einem Referenzsignal entspricht, welches einem der NB Abschnitte $B_b$ zugeordnet ist, sowie Einrichtungen (72 86) zur sequentiellen Bearheitung des Messsignals mit aufeinander folgenden zeitlichen Abschnitten, die in der Weise organisiert sind, dass für jeden Abschnitt n des Messsignals eine Bearbeitung vorgenommen wird, welche folgendes umfasst:

- für jeden der NB Abschnitte $B_b$, 0 $\leq$ b < NB: Berechnen einer akkumulierten Metrik für den Abschnitt $MBA_b$(n), indem die von der Einrichtung zur Berechnung von elementaren Metriken gelieferte elementare Metrik $MB_b(n)$ zur akkumulierten Metrik eines Zustands $MEA_e(n-1)$ hinzugefügt wird, die sich auf den Ausgangszustand $E_e$ des Abschnitts $B_b$ bezieht; und
- für jeden der NE Zustände $E_e$, 0 $\leq$ e < NE: die Aktualisierung der akkumulierten Metrik des Zustands $MEA_e$

(n), die gleich einem Optimum der akkumulierten Abschnittsmetriken $MBA_b(n)$ angesetzt wird, welche sich auf jene unter den Abschnitten $B_b$ beziehen, die den Zustand $E_e$ als Zielzustand aufweisen, und Abspeichern einer Kennung eines verbliebenen Abschnitts, für den das Optimum erreicht ist,

bei welchem die Einrichtungen zur sequentiellen Bearbeitung in der Weise organisiert sind, dass einer der NE Zustände $E_{e0}$ und ein optimaler Pfad $\alpha_{opt}$ des Gitters gewählt werden, nachdem die aufeinander folgenden Abschnitte des Messsignals bearbeitet wurden, wobei der optimale Pfad $\alpha_{opt}$ dadurch gebildet wird, dass die seit dem ausgewählten Zustand verbliebenen Abschnitte wieder zusammengebaut werden, um mindestens ein diskretes Symbol $D_m$ der zu detektierenden Abfolge anhand des Werts eines Symbols, welches der Abfolge entspricht, der der gewählte optimale Pfad zugeordnet ist, hochzurechnen, und um eine Wahrscheinlichkeit Am der Hochrechnung jedes Symbols $D_m$ zu ermitteln,
**dadurch gekennzeichnet, dass** die Einrichtungen zur sequentiellen Bearbeitung in der Weise organisiert sind, dass sie für jedes Symbol $D_m$ der zu detektierenden Abfolge, das nach Auswahl eines Zustands $E_{e0}$ und eines optimalen Pfads $\alpha_{opt}$ hochgerechnet wurde, eine kleinstmögliche Differenz der Metriken zwischen dem optimalen Pfad und einem konkurrierenden Pfad berechnen, welcher einer Abfolge zugeordnet ist, deren dem Symbol $D_m$ entsprechendes Symbol einen anderen Wert als die für das Symbol $D_m$ erhaltene Hochrechnung aufweist, und dass sie die Wahrscheinlichkeit $\Lambda_m$ der Hochrechnung des Symbols $D_m$ in Abhängigkeit von der berechneten kleinstmöglichen Differenz zwischen der Metriken ermitteln.

10. Viterbi-Prozessor nach Anspruch 9, bei weichem die Einrichtungen zur sequentiellen Bearbeitung (72; 86) die Wahrscheinlichkeit Am der Abschätzung des Symbols $D_m$ gleich der oder proportional zu der für das Symbol $D_m$ berechneten kleinstmöglichen Differenz der Metriken bestimmen.

11. Viterbi-Prozessor nach Anspruch 9 oder 10, welcher Speichereinrichtungen (73; 87) aufweist, in welchen die Einrichtungen zur sequentiellen Bearbeitung (72; 86) für jeden der NB Abschnitte $B_b$, $0 \leq b < NB$, die während der Bearbeitungsvorgänge, die für L0+L1 aufeinander folgende zeitliche Segmente n-r des Messsignals bis zu einem Segment n, n-L0-L1 < n-r $\leq$ n, vorgenommen wurden, den Abstand $\delta_b$ (n-r) = | $MBA_b$(n-r) - $MEA_e$ (n-r) | zwischen der akkumulierten Metrik des Abschnitts $MBA_b$(n-r) und der akkumulierten Metrik des Zustands $MEA_e$(n-r) aufzeichnen, welcher für den Zielzustand $E_e$ des Abschnitts $B_b$ aktualisiert wurde, wobei L0 eine ganze positive Zahl oder Null ist und wobei L1 eine strikt positive ganze Zahl ist,
und bei welchem die Einrichtungen zur sequentiellen Bearbeitung in der Weise organisiert sind, dass sie nach der Bearbeitung der L1 aufeinander folgenden Segmente des Messsignals bis zu einem Segment n und bis zur Auswahl eines Zustands $E_{e0}$ mit einer rekursiven Berechnung auf der Grundlage der Metrikabstände weiterarbeiten, die in der Speichereinrichtung aufgezeichnet wurden, um die kleinstmögliche Metrikdifferenz relativ zu jedem Symbol $D_m$ zu bestimmen, das mit Hilfe der Abfolge hochgerechnet wurde, welcher der optimale Pfad zugeordnet ist, welcher durch erneutes Zusammenfügen der seit dem ausgewählten Zustand verbliebenen Abschnitte bestimmt ist.

12. Viterbi-Prozessor nach Anspruch 11, bei welchem nach der Bearbeitung von L1 aufeinander folgenden Segmenten des Messsignals bis zu einem Segment n und der Auswahl eines Zustands die Einrichtungen zur sequentiellen Bearbeitung QxL1 Symbole $D_m$ hochrechnen, die sich auf L1 vorhergehende Segmente n-r wie zum Beispiel n-L0-L1 < n-r $\leq$ n-L0 beziehen, und die jeweiligen Wahrscheinlichkeiten bei den Hochrechnungen dieser QxL1 Symbole $D_m$ bestimmen, wobei die Hochrechnungen von Q Symbolen, die sich auf ein vorhergehendes Segment n-r beziehen, jeweils durch die Werte des Q-Pletts der Symbole gebildet werden, denen der (r+1)-te verbliebene Abschnitt des optimalen Pfads zugeordnet ist, der durch erneutes Zusammenfügen seit dem ausgewählten Zustand durchlaufen wurde.

13. Viterbi-Prozessor nach Anspruch 12, bei welchem, die Einrichtungen zur sequentiellen Bearbeitung (72; 86), sobald sie einen Zustand $E_{e0}$ nach der Bearbeitung von L1 aufeinander folgenden Segmenten des Messsignals bis zu einem Segment n ausgewählt haben, Zustandshinweise $X_e$, die sich auf NE Zustände $E_e$, $0 \leq e < NE$, beziehen, gemäß der Beziehung $X_e$ = |$MEA_e$(n) - $MEA_{e0}$(n) |initialisieren und anschließend für jeden Wert der ganzen Zahl r, die von 0 bis L0+L1-1 geht, die folgenden Operationen ausführen:

- die Auswahl des gespeicherten verbliebenen Abschnitts $B_{b0}$ für den ausgewählten Zustand $E_{e0}$ während der Bearbeitung, die für das Segment n-r ausgeführt wird, woran sich die Aktualisierung des ausgewählten Zustands $E_{e0}$ anschließt, der so angesetzt wird, als sei er der Ausgangszustand des ausgewählten verbliebenen Abschnitts $B_{b0}$;
- für jeden der NB Abschnitte $B_b$, $0 \leq b < NB$: die Berechnung eines Abschnittshinweises $Z_b$, indem dem Zu-

standshinweis $X_e$, der sich auf den Zielzustand $E_e$ des Abschnitts $B_b$ bezieht, der Abstand der Metriken $\delta_b$(n-r) hinzugefügt wird, der für den Abschnitt $B_b$ gespeichert wurde;

- für jeden der NE Zustände $E_e$, $0 \leq e < NE$: die Aktualisierung des Zustandshinweises $X_e$, der gleich dem kleinsten der Abschnittshinweise $Z_b$ angesetzt wird, welche für jene Abschnitte $B_b$ berechnet wurden, die den Zustand $E_e$ als Ausgangszustand besitzen;
- wenn r ≥ L0 ist: die Hochrechnung von Q Symbolen der zu detektierenden Abfolge anhand der Werte des Q-Pletts der Symbole, dem der ausgewählte verbliebene Abschnitt $B_{b0}$ zugeordnet ist; und
- wenn r ≥ L0 ist: für jede Hochrechnung $d^i$, die für eines der Q Symbole $D_m$ erhalten wurde, die Bestimmung der minimalen Differenz der Metriken als den kleinsten der Abschnittshinweise $Z_b$, die für jeden der Abschnitte $B_b$ berechnet wurden, welche Q-Pletts zugeordnet sind, deren dem Symbol $D_m$ entsprechendes Symbol einen Wert $d^j$ besitzt, der sich von der Hochrechnung d' unterscheidet.

14. Viterbi-Prozessor nach einem der Ansprüche 11 bis 13, bei welchem die Speichereinrichtungen (73; 87) nach dem LIFO-Modus ("last in - first out") organisiert sind.

15. Demodulator eines digitalen Signals, welcher Einrichtungen zur Hochrechnung des Kanals (69) zur Bestimmung von Bezugssignalen ($S_b$) aus einem Messsignal (R) aufweist, welche jeweils NB Abschnitten ($B_b$) eines Gitters zugeordnet sind, und welcher einen Viterbi-Prozessor (70) nach einem der Ansprüche 9 bis 14 aufweist, der die Bezugssignale und das Messsignal empfängt, welches in aufeinander folgende Segmente ($r_n$) aufgefächert ist, und der Hochrechnungen ($D_m$) von diskreten Symbolen vornimmt, welche mittels eines Modulators (62) bearbeitet wurden, sowie Wahrscheinlichkeiten ($\Lambda_m$) ermittelt, die jeweils diesen Hochrechnungen zugeordnet sind.

16. Dekodierer eines digitalen Signals, welcher einen Viterbi-Prozessor (84) nach einem der Ansprüche 9 bis 14 aufweist, der ein in aufeinander folgende Segmente ($r_n$) aufgefächertes Messsignal (R) empfängt und Hochrechnungen ($D_m$) von diskreten Symbolen erzeugt, welche mittels eines Kodierers (82) bearbeitet wurden, sowie Wahrscheinlichkeiten ($\Lambda_m$) ermittelt, die diesen Hochrechnungen jeweils zugeordnet sind.

FIG.1.

FIG.4.

FIG.5.

FIG.2.

FIG.6.

FIG.7.

FIG.3A

FIG.3B

$e0 = \text{Argmax } W_e$
$0 \leqslant e < NE$ —— 24

$X_e = W_{e0} - W_e$
$(0 \leqslant e < NE)$ —— 25

$r = 0$ —— 26

$b0 = \text{surv}_{e0}(n-r)$ —— 29

$e0 = P(b0)$ —— 30

$Y_e = +\infty$
$(0 \leqslant e < NE)$ —— 31

$b = 0$ —— 32

33 ——
$e = S(b)$
$Z_b = X_e + S_b(n \cdot r)$

$e = P(b)$
$Y_e = \min(Y_e, Z_b)$ —— 34

$b = \text{NB}-1?$ —— 35

OUI          NON

$r \geqslant LO \text{ OU}$
$n = L-1?$ —— 37

OUI          NON

36 ——
$b = b+1$

28 —— $r = r+1$

27 ——
$X_e = Y_e$
$(0 \leqslant e < NE)$

$$q = 0 \quad (39)$$

$$\begin{array}{c} m = Q \times (n-r) + q \\ i = \text{idec}(b0, q) \end{array} \quad (40)$$

$$\Delta^j = +\infty \quad (0 \leqslant j < ND) \quad (41)$$

$$b = 0 \quad (42)$$

$$j = \text{idec}(b, q) \quad (43)$$

$$b = b + 1 \quad (46)$$

$$\Delta^j = \min(\Delta^j, Z_b) \quad (44)$$

$$b = NB - 1 ? \quad (45)$$  OUI / NON

$$\begin{array}{c} \hat{D}_m = d^i \\ \Lambda_m = \min \Delta^j \\ j \neq i \end{array} \quad (47)$$

$$q = Q - 1 ? \quad (48)$$  OUI / NON

$$q = q + 1 \quad (49)$$

$$r = L0 + L1 - 1 ? \quad (50)$$  OUI / NON

$$n = L - 1 ? \quad (51)$$  OUI / NON

FIN

FIG.3C

FIG.8.